# EUROPÄISCHE PATENTSCHRIFT

(11) **EP 3 948 448 B1**
(45) Veröffentlichungstag und Bekanntmachung des Hinweises auf die Patenterteilung: **22.06.2022**
(21) Anmeldenummer: 20719633.8
(22) Anmeldetag: 16.04.2020
(51) Int. Cl.: G05B 19/042, G05B 19/05, H05K 7/14

(54) **VERFAHREN, SOFTWAREKLEMME UND KLEMMENSYSTEM ZUR ÄNDERUNG EINER STEUERUNGSSOFTWARE EINES AUTOMATISIERUNGSSYSTEMS**
METHOD, SOFTWARE TERMINAL AND SYSTEM OF TERMINALS FOR CHANGING CONTROL SOFTWARE OF AN AUTOMATION SYSTEM
PROCÉDÉ DE MODIFICATION, BORNIER COMPRENANT UN LOGICIEL, ET SYSTÈME DE BORNIERS POUR MODIFICATION D'UN LOGICIEL DE COMMANDE D'UN SYSTÈME D'AUTOMATISATION

(30) Priorität: 26.04.2019 DE 102019110884
(43) Veröffentlichungstag der Anmeldung: 09.02.2022
(73) Patentinhaber: Beckhoff Automation GmbH, 33415 Verl (DE)
(72) Erfinder: EVENBURG, Birger, 23564 Lübeck (DE); MERSCH, Henning, 33415 Verl (DE)
(74) Vertreter: Patentanwaltskanzlei WILHELM & BECK
(86) Internationale Anmeldenummer: PCT/EP2020/060742
(87) Internationale Veröffentlichungsnummer: WO 2020/216674

(56) Entgegenhaltungen:
- EP-A2- 1 852 758
- EP-A2- 2 421 344
- US-A1- 2008 301 270

## Beschreibung

Die Erfindung betrifft ein Verfahren zur Änderung einer Steuerungssoftware eines Automatisierungssystems. Die Erfindung betrifft ferner ein Automatisierungssystem, das ausgebildet ist, das Verfahren auszuführen. Die Erfindung betrifft darüber hinaus einen Teilnehmer eines solchen Automatisierungssystems.

### Stand der Technik

Moderne Automatisierungssysteme weisen einen hohen Grad an Komplexität auf und benötigen eine hochkomplexe Steuerungssoftware.

Für die Datenübertragung solch komplexer Automatisierungssysteme, bei denen eine Vielzahl von Systemteilnehmern durch eine Steuerung gegebenenfalls simultan angesteuert werden und große Mengen an Daten übertragen werden müssen, haben sich Feldbussysteme durchgesetzt. Der Vorteil solcher Feldbussysteme ist eine vereinfachte Verkabelung der einzelnen Systemteilnehmer und gleichzeitig eine nahezu störungsfreie Kommunikation der jeweiligen Teilnehmer. Die Steuerungssoftware solcher Automatisierungssysteme ist im Gegenzug jedoch hochkomplexe, sodass zur Installation oder Änderung der Systeme für gewöhnlich geschultes Fachpersonal notwendig ist.

Um Änderungen der Steuerungssoftware eines Automatisierungssystems durchführen zu können, ist somit für gewöhnlich ein hoher Programmieraufwand notwendig. Üblicherweise müssen hierfür die entsprechenden Automatisierungssysteme, oder wenigstens Teile der Automatisierungssysteme, ausgeschaltet werden und entsprechend geschultes Personal zur Programmierung der Änderung der Steuerungssoftware bestellt werden. Beides ist teuer und zeitaufwendig, da während der Programmierung der Steuerungssoftware das Automatisierungssystem stillsteht.

Alternativ ist es möglich, die Software des Automatisierungssystems mittels einer zusätzlichen Steuerung einzubinden. Dies ist jedoch durch die benötigte Controller-Controller-Synchronisation zeit- und kostenintensiv und benötigt ebenfalls geschultes Fachpersonal. Aus der Druckschrift EP 2 421 344 A2 sind Eingabe/Ausgabe-Geräte mit re-konfigurierbarer Funktionalität bekannt. Aus der Druckschrift US 2008/301270 A1 sind ein System und Verfahren zur Bereitstellung und Installation gerätespezifischer Funktionalitäten, insbesondere für Feldgeräte bekannt. Aus der Druckschrift EP 1 852 758 A2 sind ein System und Verfahren zum Bereitstellen von flexiblem und verteiltem Verarbeiten in einer industriellen Steuerumgebung bekannt. Aus der Druckschrift DE 10 2017 127766 B3 sind eine Busklemme für ein Automatisierungssystem und ein Verfahren zum Überwachen eines Versorgungsstromnetzes bekannt. Aus der Druckschrift DE 10 2015 121091 A1 ist eine Telematik-Update-Softwarekompatibilität bekannt.

### Offenbarung der Erfindung

Der Erfindung liegt die Aufgabe zugrunde, ein effizientes Verfahren zur Änderung einer Steuerungssoftware eines Automatisierungssystems, ein entsprechendes Automatisierungssystem, das ausgebildet ist, ein solches Verfahren durchzuführen, und einen Teilnehmer eines solchen Automatisierungssystems bereitzustellen.

Die Aufgabe wird mittels der Gegenstände der unabhängigen Ansprüche gelöst. Vorteilhafte Ausgestaltungen der Erfindung sind Gegenstand der jeweils abhängigen Ansprüche.

Nach einem ersten Aspekt der Erfindung wird ein Verfahren zum Ändern einer Steuerungssoftware eines Automatisierungssystems bereitgestellt, wobei das Automatisierungssystem eine Steuerung und eine Mehrzahl von Teilnehmern umfasst, wobei die Teilnehmer über einen Datenbus mit der Steuerung verbunden sind und über einen Datenaustausch kommunizieren, wobei zumindest ein Teilnehmer ein Software-Teilnehmer zum Ändern der Steuerungssoftware ist, und wobei der Software-Teilnehmer eine Speichereinheit umfasst, auf der wenigstens eine Änderungsanweisung zur Änderung der Steuerungssoftware abgespeichert ist, umfassend: Senden einer individuellen Abfragenachricht durch die Steuerung an den Software-Teilnehmer zur Abfrage der wenigstens einen Änderungsanweisung zur Änderung der Steuerungssoftware in einem Abfrageschritt, Senden einer Antwortnachricht durch den Software-Teilnehmer an die Steuerung zum Bereitstellen der wenigstens einen Änderungsanweisung zur Änderung der Steuerungssoftware in einem ersten Antwortschritt, Überprüfen der wenigstens einen Änderungsanweisung zur Änderung der Steuerungssoftware durch die Steuerung, ob die Änderungsanweisung mit der Steuerungssoftware kompatibel ist, in einem Überprüfungsschritt, Änderung der Steuerungssoftware gemäß der Änderungsanweisung durch die Steuerung in einem Änderungsschritt, wenn die Änderungsanweisung mit der Steuerungssoftware kompatibel ist, und Verwerfen der Änderungsanweisung durch die Steuerung in einem Verwerfungsschritt, wenn die Änderungsanweisung mit der Steuerungssoftware nicht kompatibel ist.

Hierdurch wird der technische Vorteil erreicht, dass ein effizientes Verfahren zur Änderung einer Steuerungssoftware eines Automatisierungssystems bereitgestellt werden kann.

Über den Software-Teilnehmer, der vorzugsweise als ein separates Bauteil, besonders bevorzugt als eine Klemme, beziehungsweise eine Bus-Klemme ausgebildet ist, kann eine vereinfachte Änderung der Steuerungssoftware eines Automatisierungssystems erzielt werden, ohne dass eine aufwendige Programmierung durch geschultes Fachpersonal benötigt wird.

Der Software-Teilnehmer fungiert in dem Automatisierungssystem als eigenständiger Teilnehmer, der mit der Steuerung über einen Datenaustausch kommunizieren kann. Der Software-Teilnehmer weist eine Speichereinheit auf, auf der eine Änderungsanweisung zur Änderung der Steuerungssoftware der Steuerung gespeichert ist. Wahlweise können auch mehrere verschiedene Änderungsanweisungen zu verschiedenen Änderungen der Steuerungssoftware des Automatisierungssystems auf der Speichereinheit gespeichert sein.

Über eine individuelle Identifizierungskennung des Software-Teilnehmers identifiziert die Steuerung den Software-Teilnehmer als einen Teilnehmer des Automatisierungssystems, wobei der Software-Teilnehmer dazu dient, eine Änderung der Steuerungssoftware des Automatisierungssystems zu bewirken. Hierauf sendet der Software-Teilnehmer die auf der Speichereinheit gespeicherten Änderungsanweisungen an die Steuerung.

Die von der Steuerung empfangenen Änderungsanweisungen des Software-Teilnehmers werden von der Steuerung auf Kompatibilität mit der bestehenden Steuerungssoftware überprüft und die entsprechende Änderung der Steuerungssoftware wird durchgeführt, wenn die Überprüfung ergeben hat, dass die jeweilige Änderung der Steuerungssoftware mit der bestehenden Steuerungssoftware kompatibel ist.

Bei einem negativen Überprüfungsergebnis, sprich bei der Feststellung, dass die den Änderungsanweisungen entsprechenden Änderungen mit der bestehenden Steuerungssoftware inkompatibel sind, verwirft die Steuerung die Änderungsanweisungen des Software-Teilnehmers und die bestehende Steuerungssoftware bleibt unverändert.

Durch die Verwendung des Software-Teilnehmers und der Änderungsanweisungen, die auf der Speichereinheit des Software-Teilnehmers gespeichert sind, kann eine zeitintensive Programmierung zur Implementierung der Änderungsanweisung in die bestehende Steuerungssoftware vermieden werden, indem gemäß dem beschriebenen Verfahren die Steuerung sich automatisch die gewünschten Änderungen von dem Software-Teilnehmer beschafft und bei positiver Kompatibilität selbständig implementiert.

Der Software-Teilnehmer ist hierzu beliebig programmierbar, sodass gewünschte Änderungen der Steuerungssoftware in entsprechenden Änderungsanweisungen auf der Speichereinheit des Software-Teilnehmers gespeichert werden können.

Zur Änderung der Steuerungssoftware ist es somit ausreichend, einen Software-Teilnehmer, der die der gewünschten Änderung der Steuerungssoftware entsprechenden Änderungsanweisungen auf dessen Speichereinheit abgespeichert hat, in das Automatisierungssystem einzufügen, sodass mittels des erfindungsgemäßen Verfahrens zur Änderung einer Steuerungssoftware eines Automatisierungssystems die Steuerung die gewünschte Änderung der Steuerungssoftware in die bestehende Steuerungssoftware implementiert.

Nach erfolgreicher Änderung der Steuerungssoftware kann der Software-Teilnehmer im Automatisierungssystem verbleiben. Der Software-Teilnehmer oder die Änderungsanweisung des Software-Teilnehmers kann derart ausgebildet sein, dass der Software-Teilnehmer nach Änderung der Steuerungssoftware im weiteren Betrieb von der Steuerung unberücksichtigt bleibt.

Eine Änderungsanweisung kann hierbei ein zu ändernder Teil der Steuerungssoftware oder ein zusätzlicher Teil der Steuerungssoftware sein. Ebenfalls können hierunter Korrekturen fehlerhafter Teile der Steuerungssoftware beziehungsweise verbesserte Versionen oder neuere Versionen in Form von Updates der Steuerungssoftware verstanden werden.

Ein Datenbus kann vorliegend ein Feldbussystem sein, an dem mehrere Teilnehmer angeschlossen sind. Das Feldbussystem kann über verschiedene Protokolle realisiert sein, beispielsweise: EtherCAT, Ethernet Power Link, CAN, Profibus, Profinet und weitere Feldbusprotokolle.

Ein Teilnehmer ist ein Knoten des Feldbussystems, der eigenständig über einen Datenaustausch mit einer Steuerung beziehungsweise weiteren Teilnehmern des Bussystems kommunizieren kann.

Ein Teilnehmer kann bereits vor Durchführung des Verfahrens zur Änderung einer Steuerungssoftware eines Automatisierungssystems Teil des Automatisierungssystems gewesen sein.

Ein Teilnehmer kann eine Eingangs-/Ausgangsklemme und ein Gerät des Automatisierungssystems umfassen. Als Software-Teilnehmer kann der Teilnehmer auch ausschließlich aus einer entsprechenden Software-Klemme bestehen. Im Folgenden kann Teilnehmer und Klemme gegebenenfalls synonym verwendet werden. Ein Teilnehmer kann auch eine Rechnereinheit sein. Beispielsweise kann in einem Bussystem, insbesondere einem Feldbussystem, ein Teilnehmer ein Master oder ein Slave des Bussystems sein.

Ein zusätzlicher Teilnehmer ist ein Teilnehmer, der mit der Durchführung des Verfahrens zur Änderung einer Steuerungssoftware eines Automatisierungssystems in das Automatisierungssystem integrierbar ist, vor Durchführung des Verfahrens zur Änderung einer Steuerungssoftware eines Automatisierungssystems aber kein Teilnehmer des Automatisierungssystems war.

Ein Software-Teilnehmer ist ein Teilnehmer des Automatisierungssystems, der zum Ändern einer Steuerungssoftware der Steuerung dient und eine Speichereinheit umfasst, auf der wenigstens eine Änderungsanweisung zur Änderung der Steuerungssoftware des Automatisierungssystems speicherbar ist.

Ein Teilnehmer kann beispielsweise eine Klemme, insbesondere eine Bus-Klemme, aufweisen, die als ein Software-Teilnehmer ausgebildet ist oder als eine Eingangs-/Ausgangs-Klemme (E/A-Klemme), an die ein Feldgerät, beispielsweise ein Aktor, ein Sensor oder ein Motor, angeschlossen ist, ausgebildet ist.

Ein Empfangen von Daten kann ein Aufnehmen von Daten und ein Senden von Daten kann ein Ausgeben von Daten sein. Beispielsweise kann ein Empfangen und Senden von Daten durch einen Teilnehmer in einem Durchlauf eines Datentelegramms durchgeführt werden, bei dem der jeweilige Teilnehmer Daten aus dem Telegramm ausliest und Daten in das gleiche Telegramm einfügt, sodass in einem Durchlauf des Telegramms Daten sowohl aus dem Telegramm ausgelesen, sprich empfangen, wie auch eingefügt, sprich ausgesendet, werden können.

Das Senden und Empfangen von Daten kann auch über das Senden und Empfangen entsprechender Datenpakete realisiert sein.

Eine Datenkommunikation kann über das Aussenden und Empfangen von Daten zwischen der Steuerung und Teilnehmern oder zwischen Teilnehmern unter sich realisiert werden. Eine Datenkommunikation kann auch über das Auslesen und Einfügen von Daten in einem Durchlauf eines Datentelegramms realisiert werden.

Nach einer Ausführungsform umfasst das Verfahren zum Ändern einer Steuerungssoftware eines Automatisierungssystems ferner: Installieren des Software-Teilnehmers in den Datenbus und Verbinden des Software-Teilnehmers mit der Steuerung in einem ersten Installationsschritt, Senden einer Identifizierungsabfrage durch die Steuerung an die Teilnehmer zur Identifizierung der im Datenbus befindlichen Teilnehmer in einem Abfrageschritt, Senden einer Identifizierungsantwort durch den Software-Teilnehmer an die Steuerung in einem ersten Antwortschritt, und Identifizieren des Software-Teilnehmers als einen Teilnehmer zur Änderung der Steuerungssoftware durch die Steuerung auf Basis der Identifizierungsantwort in einem ersten Identifizierungsschritt.

Hierdurch wird der technische Vorteil erreicht, dass ein effizientes Verfahren zur Änderung einer Steuerungssoftware eines Automatisierungssystems bereitgestellt werden kann.

Eine Änderung der Steuerungssoftware eines Automatisierungssystems ist durch eine Installation des Software-Teilnehmers in den Datenbus des Automatisierungssystems erzielbar. Hierzu kann der Software-Teilnehmer an einer geeigneten Stelle in das Automatisierungssystem integriert und mittels entsprechenden Anschlüssen an die jeweilige Verkabelung des Datenbusses in den Datenbus eingepflegt werden.

Über eine entsprechende Identifizierungsabfrage durch die Steuerung an die Teilnehmer des Automatisierungssystems kann die Steuerung jeden der im Datenbus befindlichen Teilnehmer registrieren und als einen bestimmten Teilnehmer identifizieren.

In diesem Zusammenhang erkennt die Steuerung den Software-Teilnehmer als einen Teilnehmer des Automatisierungssystems, der dazu dient, eine Änderung der Steuerungssoftware des Automatisierungssystems zu bewirken.

Nach Identifizierung des Software-Teilnehmers durch die Steuerung als einen Teilnehmer, der zur Änderung der Steuerungssoftware des Automatisierungssystems dient, fordert die Steuerung den Software-Teilnehmer zur Übermittlung einer entsprechenden Änderungsanweisung zur Änderung der Steuerungssoftware auf.

Es kann somit vermieden werden, dass zur Änderung der Steuerungssoftware ein Programmieraufwand betrieben werden muss. Ferner muss der Steuerung der für die Änderung der Steuerungssoftware zuständige Software-Teilnehmer nicht extra in einem zusätzlichen Programmieraufwand genannt werden.

Nach einer Ausführungsform umfasst der Verwerfungsschritt:
Ausgeben einer Fehlermeldung durch die Steuerung in einem Fehlermeldungsschritt.

Hierdurch wird der technische Vorteil erreicht, dass dem Nutzer angezeigt wird, dass der installierte Software-Teilnehmer fehlerhaft ist, beziehungsweise die Änderungsanweisung nicht mit der bestehenden Steuerungssoftware kompatibel ist.

Nach einer Ausführungsform ist das Verfahren zum Ändern einer Steuerungssoftware eines Automatisierungssystems in einer Startphase des Automatisierungssystems, in der das Automatisierungssystem nicht in Betrieb ist, oder in einem laufenden Betrieb des Automatisierungssystems durchführbar.

Hierdurch kann erreicht werden, dass zur Änderung der Steuerungssoftware des Automatisierungssystems mittels des erfindungsgemäßen Verfahrens das Automatisierungssystem nicht extra in einen für die Änderung der Steuerungssoftware geeigneten Zustand versetzt werden muss.

Stattdessen kann eine Änderung der Steuerungssoftware in einer Startphase des Automatisierungssystems bewirkt werden. Hierzu wird in einem abgeschalteten Zustand des Automatisierungssystems der Software-Teilnehmer in den Datenbus des Automatisierungssystems eingefügt.

Darauffolgend wird in einer Startphase des Automatisierungssystems, in der ein Auffahren der Steuerungssoftware durchgeführt wird, durch die Steuerung der zusätzlich in das Automatisierungssystem eingefügte Software-Teilnehmer als zusätzlicher Teilnehmer erkannt.

Hierauf folgend wird der Software-Teilnehmer, wie oben beschrieben, durch die Steuerung als Software-Teilnehmer identifiziert und dieser stellt der Steuerung die entsprechende Änderungsanweisung zur Änderung der Steuerungssoftware bereit.

Nachfolgend überprüft die Steuerung die bereitgestellte Änderungsanweisung bezüglich einer Kompatibilität der durch die Änderungsanweisung bestimmten Änderung der Steuerungssoftware mit der bestehenden Steuerungssoftware und installiert beziehungsweise implementiert die gewünschte Änderung der Steuerungssoftware, wenn die Überprüfung eine Kompatibilität der gewünschten Änderung mit der bestehenden Steuerungssoftware ergibt.

Die Änderung der Steuerungssoftware ist damit während der Startphase des Automatisierungssystems, in der die Steuerungssoftware aufgefahren wird, abgeschlossen, sodass ein Betrieb des Automatisierungssystems vor Abschluss der Startphase mit geänderter Steuerungssoftware durchgeführt werden kann.

Alternativ kann die Änderung der Steuerungssoftware gemäß dem erfindungsgemäßen Verfahren auch während des Betriebs des Automatisierungssystems durchgeführt werden. Hierzu wird der Software-Teilnehmer in einen Bereich des Automatisierungssystems eingefügt, der zum Zeitpunkt der Installation sich nicht in einem Betriebszustand, sondern in einem Konfigurationszustand befindet.

Nach Abschluss der wie oben beschriebenen Installation des Software-Teilnehmers in den Datenbus des Automatisierungssystems erkennt die Steuerung den Software-Teilnehmer als zusätzlichen Teilnehmer und führt die wie oben beschriebenen Schritte zur Änderung der Steuerungssoftware gemäß der Änderungsanweisung des Software-Teilnehmers durch. Eine Änderung der Steuerungssoftware kann somit abgeschlossen werden, bevor der jeweilige Teil des Automatisierungssystems erneut in den Betriebszustand geführt wird. Ein Stillstand des Automatisierungssystems zur Änderung der Steuerungssoftware ist folglich nicht erforderlich.

Nach einer Ausführungsform umfasst die Änderungsanweisung eine Identifizierung, eine Steuerungssoftware, spezifische Betriebsparameter, eine Lizensierung der Steuerungssoftware oder ähnliches wenigstens eines Teilnehmers des Automatisierungssystems.

Hierdurch wird der technische Vorteil erreicht, dass mit der Änderung der Steuerungssoftware mittels der Änderungsanweisung des Software-Teilnehmers eine Änderung einer Steuerungssoftware eines Teilnehmers des Automatisierungssystems bewirkt werden kann.

Beispielsweise kann über das erfindungsgemäße Verfahren die Installation eines zusätzlichen Teilnehmers beziehungsweise das Ersetzen eines bestehenden Teilnehmers des Automatisierungssystems durch einen neuen Teilnehmer erreicht werden. Hierzu kann zusätzlich zu der oben beschriebenen Installation des Software-Teilnehmers ein zusätzlicher Teilnehmer in das Automatisierungssystem eingefügt beziehungsweise ein bestehender Teilnehmer durch einen neuen Teilnehmer ersetzt werden.

In den wie oben beschriebenen Schritten werden der Software-Teilnehmer und der zusätzliche beziehungsweise neue Teilnehmer des Automatisierungssystems durch die Steuerung als Teilnehmer erkannt und die Steuerungssoftware gemäß der Änderungsanweisung des Software-Teilnehmers geändert.

Die Änderung der Steuerungssoftware umfasst hierbei das Einfügen der zusätzlichen Steuerungssoftware des zusätzlichen Teilnehmers beziehungsweise die entsprechende Änderung der Steuerungssoftware des ursprünglichen Teilnehmers, sowie die Adressierung und weitere Schritte, die für den Betrieb des zusätzlichen Teilnehmers innerhalb des Automatisierungssystems durch die Steuerung notwendig sind.

Nach Änderung des Steuerungssoftware gemäß der auf dem Software-Teilnehmer gespeicherten Änderungsanweisung ist der zusätzliche Teilnehmer in das Automatisierungssystem eingefügt und kann angesteuert und betrieben werden.

Sobald eine Startphase des Automatisierungssystems abgeschlossen ist beziehungsweise der jeweilige Bereich des Automatisierungssystems, in dem der Software-Teilnehmer und der zusätzliche Teilnehmer installiert sind, wieder in einen Betriebszustand gebracht ist, ist der zusätzliche Teilnehmer beziehungsweise der neue Teilnehmer in das Automatisierungssystem eingefügt und kann durch die Steuerung gemäß der entsprechenden Steuerungssoftware des Teilnehmers beziehungsweise der spezifischen Betriebsparameter des Teilnehmers betrieben werden.

Nach erfolgreicher Änderung der Steuerungssoftware und erfolgreicher Installation des zusätzlichen Teilnehmers kann der Software-Teilnehmer im Automatisierungssystem verbleiben.

Darüber hinaus kann mittels einer entsprechenden Lizensierung der Steuerungssoftware des zusätzlichen beziehungsweise neuen Teilnehmers gesichert werden, dass ausschließlich Teilnehmer in ein bestehendes Automatisierungssystem eingefügt werden, die entsprechenden Anforderungen, beispielsweise Qualitätsanforderungen oder Sicherheitsanforderungen, entsprechen, sodass ein Qualitäts- und Sicherheitsstandard gewahrt werden kann.

Ein zusätzlicher Teilnehmer, der wie oben beschrieben in ein bestehendes Automatisierungssystem eingefügt wird, kann beispielsweise einen Aktor, einen Sensor, einen Motor oder ein ähnliches Gerät für ein Automatisierungssystem umfassen.

Nach einer Ausführungsform umfasst der Software-Teilnehmer eine Klemme, insbesondere eine Bus-Klemme, die zur Datenübertragung in einem Datenbus ausgebildet ist, und eine Speichereinheit, die in der Klemme angeordnet ist und auf der wenigstens einen Änderungsanweisung gespeichert werden kann, wobei die Klemme ferner ausgebildet ist, die wenigstens eine Änderungsanweisung an die Steuerung des Automatisierungssystems zu senden.

Hierdurch wird der technische Vorteil einer einfachen Installation des Software-Teilnehmers erreicht. Zur Installation des Software-Teilnehmers kann die jeweilige Bus-Klemme des Software-Teilnehmers mit den entsprechenden Anschlüssen an die Busleitungen des Datenbusses angeschlossen werden. Mittels der Anschalteinheit der Bus-Klemme des Software-Teilnehmers kann der Software-Teilnehmer über den Datenbus mit der Steuerung kommunizieren. Die Anschalteinheit dient dazu, eine Kommunikation mit einer Steuerung beziehungsweise weiteren Teilnehmern eines Automatisierungssystems bereitzustellen. Die Anschalteinheit kann eine Empfangseinheit und eine Sendeeinheit aufweisen und somit das Empfangen beziehungsweise das Aussenden von Daten ermöglichen. Das Empfangen und Aussenden von Daten kann auch in einem Durchlauf eines Datentelegramms durchgeführt werden, bei dem die Anschalteinheit Daten aus dem Telegramm ausgelesen und Daten in das gleiche Telegramm eingefügt werden können. Auf der Speichereinheit der Bus-Klemme kann eine entsprechende Änderungsanweisung gespeichert werden.

Alternativ können auf der Speichereinheit der Bus-Klemme des Software-Teilnehmers eine Mehrzahl von Änderungsanweisungen gespeichert werden.

Nach Installation des Software-Teilnehmers in das Automatisierungssystem kann der Software-Teilnehmer nach entsprechenden Abfragenachrichten der Steuerung über die Anschalteinheit der Bus-Klemme des Software-Teilnehmers die auf der Speichereinheit gespeicherten Änderungsanweisungen der Steuerung bereitstellen.

Nach einer Ausführungsform ist die Speichereinheit des Software-Teilnehmers im Betrieb des Automatisierungssystems nicht mit Daten durch die Steuerung beschreibbar.

Hierdurch kann erreicht werden, dass der Software-Teilnehmer lediglich zur Bereitstellung der Änderungsanweisung zur Änderung der Steuerungssoftware verwendet wird. Somit kann vermieden werden, dass nach Installation des Software-Teilnehmers dieser mittels nachträglicher Beschreibung für andere Zwecke verwendet wird.

Außerdem kann gewährleistet werden, dass bei Installation mehrerer Software-Teilnehmer gleichen Typs, die entsprechenden zusätzlichen Teilnehmer mit der identischen Änderungsanweisung installiert werden. Dies kann zur Systemsicherheit beitragen.

Darüber hinaus kann vermieden werden, dass eine Änderung der Steuerungssoftware des Automatisierungssystems erreicht wird, die über die auf der Speichereinheit des Software-Teilnehmers gespeicherte Änderungsanweisung hinausgeht. Somit ist die Änderung der Steuerungssoftware durch die auf der Speichereinheit des Software-Teilnehmers gespeicherte Änderungsanweisung nachvollziehbar. Dies erleichtert gegebenenfalls eine Fehleranalyse bei einer Änderung der Steuerungssoftware, die zu einer fehlerhaften Steuerungssoftware geführt hat.

Nach einer Ausführungsform umfassen die Teilnehmer des Automatisierungssystems jeweils eine Bus-Klemme, insbesondere eine E/A-Klemme und wenigstens einen Aktor, einen Motor, einen Sensor oder ein weiteres Gerät für ein Automatisierungssystem, das an der Klemme angeschlossen ist, wobei die Klemme ausgebildet ist, in den Datenbus integriert zu werden und über einen Datenaustausch mit der Steuerung und/oder weiteren Teilnehmern zu kommunizieren.

Hierdurch wird der technische Vorteil erreicht, dass durch das erfindungsgemäße Verfahren zusätzliche Teilnehmer, die einen Aktor, einen Motor, einen Sensor oder ein weiteres Gerät für ein Automatisierungssystem umfassen, in das Automatisierungssystem eingefügt werden können. Über die E/A-Klemmen können die zuvor beschriebenen Geräte in den Datenbus des Automatisierungssystems eingefügt und über die Steuerung des Automatisierungssystems betrieben werden.

Wie oben beschrieben, können somit über das erfindungsgemäße Verfahren beliebige Geräte, die für den Betrieb einer Änderung des Automatisierungssystems benötigt werden, in das bestehende Automatisierungssystem eingefügt werden.

Das bestehende Automatisierungssystem kann somit auf einfache Weise um zusätzliche Geräte erweitert oder durch den Austausch bestehender Geräte mit neuen oder anderen Geräten geändert werden.

Nach einer Ausführungsform sind die Klemme des Software-Teilnehmers und die Teilnehmerklemmen der weiteren Teilnehmer in einem Klemmensystem, das eine Mehrzahl von Klemmen umfasst, verbindbar, wobei die Klemmen innerhalb des Klemmensystems durch einen Datenbus miteinander verbunden sind und mittels einer Datenübertragung über den Datenbus miteinander kommunizieren können.

Dadurch wird der technische Vorteil einer kompakten Verschaltung des Automatisierungssystems erreicht. Durch das Zusammenführen der einzelnen Klemmen der Teilnehmer des Automatisierungssystems in ein Klemmensystem kann eine kompakte und platzsparende Verschaltung der Geräte des Automatisierungssystems erreicht werden.

Nach einem zweiten Aspekt der vorliegenden Erfindung wird ein Automatisierungssystem bereitgestellt, das eine Steuerung und eine Mehrzahl von Teilnehmern umfasst, die mit der Steuerung über einen Datenbus verbunden sind und über den Austausch von Daten mit der Steuerung kommunizieren können, wobei die Steuerung mit einer Steuerungssoftware die Mehrzahl von Teilnehmer ansteuert, wobei wenigstens ein Teilnehmer ein Software-Teilnehmer ist, wobei der Software-Teilnehmer eine Speichereinheit umfasst, auf der wenigstens eine Änderungsanweisung zur Änderung der Steuerungssoftware der Steuerung gespeichert ist, wobei die Steuerung ausgebildet ist, eine individuelle Abfragenachricht an den Software-Teilnehmer zur Abfrage der wenigstens einen Änderungsanweisung zur Änderung der Steuerungssoftware zu senden, wobei der Software-Teilnehmer ausgebildet ist, die wenigstens eine Steuerungsanweisung zur Änderung der Steuerungssoftware an die Steuerung zu senden, wobei die Steuerung ausgebildet ist, die wenigstens eine Änderungsanweisung zur Änderung der Steuerungssoftware zu überprüfen, ob die Änderungsanweisung mit der Steuerungssoftware kompatibel ist, wobei die Steuerung ausgebildet ist, die Steuerungssoftware gemäß der Änderungsanweisung zu ändern, wenn die Änderungsanweisung mit der Steuerungssoftware kompatibel ist, und wobei die Steuerung ausgebildet ist, die Änderungsanweisung zu verwerfen, wenn die Änderungsanweisung mit der Steuerungssoftware nicht kompatibel ist.

Hierdurch kann ein Automatisierungssystem bereitgestellt werden, das eine vereinfachte Änderung der Steuerungssoftware des Automatisierungssystems ermöglicht. Ein zusätzlicher Programmieraufwand zur Änderung der Steuerungssoftware des Automatisierungssystems kann somit vermieden werden.

Nach Erkennen des Software-Teilnehmers als einen Teilnehmer zur Änderung der Steuerungssoftware durch die Steuerung ist die Steuerung in der Lage, mittels einer entsprechenden Abfragenachricht den Software-Teilnehmer zur Übermittlung einer auf der Speichereinheit des Software-Teilnehmers gespeicherten Änderungsanweisung anzutreiben.

Nach Übermittlung der entsprechenden Änderungsanweisung durch den Software-Teilnehmer an die Steuerung ist diese wiederum in der Lage, die der Änderungsanweisung entsprechende gewünschte Änderung hinsichtlich einer Kompatibilität mit der bereits bestehenden Steuerungssoftware zu prüfen und bei einer erkannten Kompatibilität die Steuerungssoftware der Änderungsanweisung entsprechend zu ändern.

Auf einen Programmieraufwand durch ein geschultes Fachpersonal zur Änderung der Steuerungssoftware des Automatisierungssystems kann beim erfindungsgemäßen Automatisierungssystem verzichtet werden. Eine Änderung der Steuerungssoftware kann wie oben beschrieben durch eine Installation eines Software-Teilnehmers, auf dem eine entsprechende Änderungsanweisung zur Änderung der Steuerungssoftware des Automatisierungssystems gespeichert ist, automatisch bewirkt werden.

Nach einer Ausführungsform ist die Steuerung ferner ausgebildet, eine Identifizierungsabfrage an die Teilnehmer zur Identifizierung der im Datenbus befindlichen Teilnehmer zu senden, wobei der Software-Teilnehmer ausgebildet ist, eine Identifizierungsantwort an die Steuerung zu senden, und wobei die Steuerung ausgebildet ist, auf Basis der Identifizierungsantwort den Software-Teilnehmer als einen Teilnehmer zur Änderung der Steuerungssoftware des Automatisierungssystems zu identifizieren.

Hierdurch wird der technische Vorteil erreicht, dass ein Automatisierungssystem bereitgestellt werden kann, bei dem eine Änderung der Steuerungssoftware des Automatisierungssystems ohne einen zusätzlichen Programmieraufwand durch ein geschultes Fachpersonal erreicht werden kann.

Wie oben beschrieben ist zur Änderung der Steuerungssoftware im erfindungsgemäßen Automatisierungssystem lediglich eine Installation des entsprechenden Software-Teilnehmers nötig. Nach erfolgreicher Installation des Software-Teilnehmers identifiziert die Steuerung den Software-Teilnehmer als einen Teilnehmer des Automatisierungssystems, der zur Änderung der Steuerungssoftware dient.

Mit dieser Information ist die Steuerung in der Lage, wie oben bereits beschrieben, den Software-Teilnehmer dazu zu bewegen, die entsprechende Änderungsanweisung zur Änderung der Steuerungssoftware der Steuerung bereitzustellen.

Mit dieser bereitgestellten Änderungsanweisung ist die Steuerung wiederum in der Lage, die entsprechende Änderung der Steuerungssoftware selbständig durchzuführen, sofern die entsprechende Änderung mit der bereits bestehenden Steuerungssoftware kompatibel ist.

Nach einer Ausführungsform sind die Steuerung und der Software-Teilnehmer ausgebildet, eine Änderung der Steuerungssoftware gemäß der wenigstens einen Änderungsanweisung in einer Startphase des Automatisierungssystems, in der das Automatisierungssystem nicht in Betrieb ist, oder in einem laufenden Betrieb des Automatisierungssystems durchzuführen.

Hierdurch wird der technische Vorteil erreicht, dass ein Automatisierungssystem bereitgestellt werden kann, das zu einer Änderung der Steuerungssoftware des Automatisierungssystems nicht in einen extra zur Änderung der Steuerungssoftware bestimmten Zustand versetzt werden muss.

Stattdessen kann die Änderung der Steuerungssoftware mittels des Software-Teilnehmers in einer Startphase des Automatisierungssystems, in der das Automatisierungssystem von einem Zustand, in dem das Automatisierungssystem nicht in Betrieb ist, in einen Betriebszustand hochgefahren wird, bewirkt werden.

Wie bereits oben beschrieben erkennt die Steuerung nach Installation des Software-Teilnehmers beim Auffahren der Steuerungssoftware neben den bereits bestehenden Teilnehmern des Automatisierungssystems den Software-Teilnehmer als einen zusätzlichen Teilnehmer des Automatisierungssystems.

Ferner identifiziert die Steuerung den Software-Teilnehmer als einen Teilnehmer, der zur Änderung der Steuerungssoftware dient, und veranlasst den Software-Teilnehmer mit entsprechenden Abfragenachrichten, eine Änderungsanweisung beziehungsweise eine Mehrzahl von Änderungsanweisungen, die auf einer Speichereinheit des Software-Teilnehmers gespeichert sind, der Steuerung bereitzustellen.

Im Zuge des Auffahrens der Steuerungssoftware überprüft die Steuerung die den Änderungsanweisungen entsprechenden Änderungen hinsichtlich einer Kompatibilität mit der bereits bestehenden Software und führt bei gegebener Kompatibilität die jeweiligen Änderungen der Steuerungssoftware durch.

Bei Abschluss der Startphase kann das Automatisierungssystem somit mit der entsprechend geänderten Steuerungssoftware betrieben werden.

Alternativ kann die Änderung der Steuerungssoftware auch während des Betriebs des Automatisierungssystems durchgeführt werden. Hierzu kann der Software-Teilnehmer in einem Bereich des Automatisierungssystems installiert werden, der zum Zeitpunkt der gewünschten Änderung der Steuerungssoftware sich nicht in einem Betriebszustand, sondern in einem Konfigurationszustand befindet.

Hierzu kann die Steuerung ausgebildet sein, Teile des Automatisierungssystems, die zu einem bestimmten Zeitpunkt nicht aktiv sind, in einen Konfigurationszustand zu versetzen, in dem Konfigurationsprozesse durchgeführt werden. Konfigurationsprozesse können hierbei Überprüfungsprozesse bezüglich des Zustands der Teilnehmer, bezüglich der Zuordnung der Teilnehmer und bezüglich weiterer Faktoren umfassen, die zu einem reibungslosen Betrieb der jeweiligen Teilnehmer und des Automatisierungssystems zu überprüfen sind.

Die Steuerung ist damit in der Lage, durch Aussenden entsprechender Abfragenachrichten im Konfigurationsmodus den Software-Teilnehmer als zusätzlichen Teilnehmer des Automatisierungssystems zu erkennen und als einen Teilnehmer zu identifizieren, der zur Änderung der Steuerungssoftware dient.

Darauffolgend ist die Steuerung in der Lage, den Software-Teilnehmer zum Bereitstellen der Änderungsanweisung anzutreiben und die entsprechende Änderung der Steuerungssoftware gegebenenfalls durchführen, wenn diese mit der bestehenden Steuerungssoftware kompatibel ist.

Hierfür sendet die Steuerung an die Teilnehmer in dem Bereich des Automatisierungssystems, der sich zur Zeit der Änderung der Steuerungssoftware im Konfigurationszustand befindet, entsprechende Abfragenachrichten aus, um die dort befindlichen Teilnehmer zu identifizieren und gegebenenfalls eine Topologieänderung des Automatisierungssystems durch das Hinzufügen eines zusätzlichen Teilnehmers, beispielsweise des Software-Teilnehmers, zu erkennen.

Hierauf ist die Steuerung in der Lage, den Software-Teilnehmer als einen Teilnehmer zu identifizieren, der zur Änderung der Steuerungssoftware dient, und den Software-Teilnehmer anzutreiben, die entsprechende Änderungsanweisung zur Änderung der Steuerungssoftware bereitzustellen. Darauffolgend ist die Steuerung in der Lage, eine Änderung der Steuerungssoftware entsprechend der bereitgestellten Änderungsanweisungen durchzuführen, falls eine solche Änderung mit der bestehenden Steuerungssoftware kompatibel ist.

Die entsprechende Änderung der Steuerungssoftware bezieht sich hierbei vorzugsweise auf Teilnehmer des Bereichs, der sich zur Zeit der Änderung der Steuerungssoftware im Konfigurationszustand befindet. So kann vermieden werden, dass eine Änderung der Steuerungssoftware bezüglich Teilnehmern, die sich bereits im Betriebszustand befinden, durchgeführt wird.

Sobald die Teilnehmer des Bereichs, für den die Änderung der Steuerungssoftware vorgenommen wurde, und der sich zum Zeitpunkt der Änderung der Steuerungssoftware im Konfigurationszustand befand, wieder in den Betriebszustand gebracht werden, ist die Änderung der Steuerungssoftware beendet und die jeweiligen Teilnehmer können mit entsprechend geänderter Steuerungssoftware betrieben werden.

Nach einer Ausführungsform ist die Steuerung ausgebildet, durch die Änderung der Steuerungssoftware auf Basis der wenigstens einen Änderungsanweisung einen zusätzlichen Teilnehmer in das Steuerungssystem einzupflegen.

Hierdurch wird der technische Vorteil erreicht, dass ein Automatisierungssystem bereitgestellt wird, bei dem eine Erweiterung des Automatisierungssystems durch Hinzufügen zusätzlicher Teilnehmer ohne einen zusätzlichen Programmieraufwand durch ein geschultes Personal durchführbar ist.

Hierzu kann zusätzlich zu dem Software-Teilnehmer ein zusätzlicher Teilnehmer in das Automatisierungssystem eingefügt werden, wobei die für den Betrieb des zusätzlichen Teilnehmers benötigte Steuerungssoftware sowie spezifische Betriebsparameter und weitere Informationen auf der Speichereinheit des Software-Teilnehmers gespeichert sind.

Wie oben beschrieben erkennt die Steuerung durch Aussenden entsprechender Abfragenachrichten den Software-Teilnehmer sowie den zusätzlichen Teilnehmer als neue Teilnehmer des Automatisierungssystems und identifiziert den Software-Teilnehmer als einen Teilnehmer, der zur Änderung der Steuerungssoftware dient. In den darauffolgenden Schritten kann die Steuerung die auf der Änderungsanweisung basierende Änderung der Steuerungssoftware des Automatisierungssystems durchführen und somit den zusätzlichen Teilnehmer in die Steuerungssoftware einpflegen.

Nach Abschluss der Änderungen der Steuerungssoftware kann der zusätzliche Teilnehmer durch die Steuerung in Betrieb genommen werden. Ein zusätzlicher Programmieraufwand durch geschultes Fachpersonal, um den zusätzlichen Teilnehmer in die Steuerungssoftware der Steuerung einzupflegen, ist somit nicht notwendig.

Folglich kann eine einfache Erweiterung des Automatisierungssystems durch ein Hinzufügen zusätzlicher Geräte oder Teilnehmer oder eine Änderung des Automatisierungssystem durch einen Austausch bestehender Geräte oder Teilnehmer durch neue oder andere Geräte oder Teilnehmer dadurch realisiert werden, dass lediglich der jeweilige Teilnehmer beziehungsweise eine Mehrzahl von Teilnehmern, die zur Erweiterung in das Automatisierungssystem eingefügt werden sollen, und ein entsprechender Software-Teilnehmer, auf dessen Speichereinheit die jeweilige Steuerungssoftware beziehungsweise die entsprechenden Betriebsparameter und die jeweiligen Anweisung zur entsprechenden Änderung der Steuerungssoftware gespeichert sind, installiert werden.

Die entsprechende Änderung der Steuerungssoftware wird darauffolgend in den wie oben beschriebenen Schritten durch die Steuerung automatisch durchgeführt.

Nach Änderung der Steuerungssoftware gemäß der auf dem Software-Teilnehmer gespeicherten Software kann der zusätzliche Teilnehmer oder die Mehrzahl von zusätzlichen Teilnehmern und die jeweiligen Geräte dieser Teilnehmer durch die Steuerung des Automatisierungssystems angesteuert und innerhalb des Automatisierungssystems betrieben werden.

Nach einer Ausführungsform umfasst die Änderungsanweisung ein Update oder eine Modifikation der Steuerungssoftware.

Hierdurch wird eine einfach zu realisierende Modifikation der Steuerungssoftware erreicht. Somit kann beispielsweise zur Durchführung eines Updates oder zur Installation einer neueren Version der Steuerungssoftware ein Software-Teilnehmer in das System installiert werden, auf dessen Speichereinheit das entsprechende Update beziehungsweise die entsprechende neuere Version der Steuerungssoftware gespeichert ist. Eine Installation des Updates oder der neueren Version der Steuerungssoftware kann dann wie oben beschrieben durch die Steuerung automatisch durchgeführt werden.

Somit kann beispielsweise die Durchführung eines Updates beziehungsweise die Installation einer neueren Version der Steuerungssoftware in einem Offline-Zustand des Automatisierungssystems durchgeführt werden, bei dem das Automatisierungssystem über keinen Zugang zu einem Netzwerkserver, der das entsprechende Update beziehungsweise die entsprechende neuere Version der Steuerungssoftware umfasst, verfügt.

Ferner kann zur Durchführung des Updates beziehungsweise der Installation der neueren Version der Steuerungssoftware auf einen zusätzlichen Programmieraufwand durch geschultes Fachpersonal verzichtet werden.

Der Software-Teilnehmer kann somit auch ausschließlich zur Änderung der Steuerungssoftware eines Automatisierungssystems verwendet werden, ohne dass hierbei ein zusätzlicher Teilnehmer in das Automatisierungssystems eingeführt wird, als Erweiterung des Automatisierungssystems oder als Ersatz eines bereits bestehenden Teilnehmers. Somit kann über die Installation des Software-Teilnehmers eine automatische Änderung der Steuerungssoftware erreicht werden.

Nach einer Ausführungsform umfasst die Änderungsanweisung eine Identifizierung, eine Steuerungssoftware, spezifische Betriebsparameter, eine Lizensierung der Steuerungssoftware oder ähnliches zumindest eines Teilnehmers des Automatisierungssystems.

Hierdurch wird erreicht, dass durch die Installation des Software-Teilnehmers und eines zusätzlichen Teilnehmers eine Erweiterung des Automatisierungssystems erreicht werden kann, ohne dass zur entsprechenden Änderung der Steuerungssoftware des Automatisierungssystems ein zusätzlicher Programmieraufwand nötig wird.

Wie oben beschrieben ist die Steuerung in der Lage, nach Identifizierung des Software-Teilnehmers und des Teilnehmers die entsprechende Steuerungssoftware des zusätzlichen Teilnehmers beziehungsweise spezifische Betriebsparameter oder weitere Identifizierungskennungen des zusätzlichen Teilnehmers, die jeweils auf der Speichereinheit des Software-Teilnehmers gespeichert sind, in die Steuerungssoftware des Automatisierungssystems einzupflegen. Somit kann nach Beendigung der Änderungen der Steuerungssoftware des Automatisierungssystems der hinzugefügte Teilnehmer durch die Steuerung angesteuert werden.

Nach einem dritten Aspekt der vorliegenden Erfindung wird eine Softwareklemme zur Änderung einer Steuerungssoftware einer Steuerung eines Automatisierungssystems bereitgestellt, wobei das Automatisierungssystem eine Mehrzahl von Teilnehmern umfasst, die über einen Datenbus mit der Steuerung verbunden sind, wobei die Softwareklemme ein Teilnehmer in dem Steuerungssystem ist und als eine Bus-Klemme zur Verwendung in dem Datenbus ausgebildet ist, wobei die Softwareklemme wenigstens eine Speichereinheit aufweist, auf der wenigstens eine Änderungsanweisung zur Änderung einer Steuerungssoftware des Automatisierungssystems speicherbar ist, und wobei die Softwareklemme eine Anschalteinheit aufweist, die ausgebildet ist, mit der Steuerung und/oder anderen Teilnehmern des Datenbusses über den Austausch von Daten zu kommunizieren und der Steuerung des Automatisierungssystems wenigstens eine auf der Speichereinheit gespeicherte Änderungsanweisung zur Änderung der Steuerungssoftware des Automatisierungssystems bereitzustellen.

Hierdurch wird der technische Vorteil erreicht, dass eine einfache Lösung zur Änderung einer Steuerungssoftware eines Automatisierungssystems bereitgestellt werden kann. Mittels der Softwareklemme kann eine Änderung der Steuerungssoftware des Automatisierungssystems erreicht werden, indem die Softwareklemme an einer entsprechenden Stelle in das Automatisierungssystem eingefügt wird und die Steuerung anhand der auf einer Speichereinheit der Softwareklemme gespeicherten Änderungsanweisung eine Änderung der Steuerungssoftware des Automatisierungssystems durchführt.

Hierzu kommunizieren die Steuerung und die Anschalteinheit der Softwareklemme über den Austausch entsprechender Abfragenachrichten und Antwortnachrichten über einen Datenbus des Automatisierungssystems miteinander und die Softwareklemme stellt der Steuerung über die Anschalteinheit die entsprechende Änderungsanweisung bereit.

Die Installation der Softwareklemme ist denkbar einfach und setzt lediglich ein Anschließen der entsprechenden Kontakte der Softwareklemme mit den jeweiligen Busleitungen des Datenbusses des Automatisierungssystems voraus.

Nach einer Ausführungsform ist die Softwareklemme mit den Teilnehmerklemmen weiterer Teilnehmer verbindbar, wobei die Softwareklemme über eine Datenbusleitung des Automatisierungssystems mit den Teilnehmerklemmen kommunizieren kann.

Hierdurch wird der technische Vorteil erreicht, dass die Softwareklemme mit weiteren Teilnehmerklemmen des Automatisierungssystems zu einem Klemmensystem zusammengefasst werden kann. Die einzelnen Klemmen des Klemmensystems können über eine entsprechende Datenbusleitung, die beispielsweise einen K-Bus (Kommunikationsbus) bestimmt, untereinander kommunizieren. Hierdurch wird wiederum eine kompakte Bauweise der Verschaltung des Automatisierungssystems erreicht.

Nach einem vierten Aspekt der vorliegenden Erfindung wird ein Klemmensystem zur Verwendung in einem Automatisierungssystem bereitgestellt, welches umfasst: eine Mehrzahl von Teilnehmerklemmen und wenigstens eine Softwareklemme, wobei die Mehrzahl von Teilnehmerklemmen und die wenigstens eine Softwareklemme als Bus-Klemmen ausgebildet sind und über eine interne Busleitung des Klemmensystems miteinander verbunden sind, und einen Buskoppler, wobei der Buskoppler ausgebildet ist, das Klemmensystem an einen Datenbus des Automatisierungssystems anzubinden, und wobei die wenigstens eine Softwareklemme eine Anschalteinheit und wenigstens eine Speichereinheit umfasst und ausgebildet ist, über die Anschalteinheit einer Steuerung des Automatisierungssystems wenigstens eine auf der Speichereinheit gespeicherte Änderungsanweisung zur Änderung einer Steuerungssoftware des Automatisierungssystems bereitzustellen.

Hierdurch wird der technische Vorteil erreicht, dass eine kompakte Einheit bereitgestellt wird, die es ermöglicht, eine einfache Änderung der Steuerungssoftware eines Automatisierungssystems zu bewirken. Des Weiteren kann mit dem erfindungsgemäßen Klemmensystem eine Erweiterung eines Automatisierungssystems um zusätzliche Teilnehmer bewirkt werden.

Mittels der Installation des Klemmensystems und der darin angeordneten Softwareklemme kann eine wie oben beschriebene Änderung der Steuerungssoftware des Automatisierungssystems erreicht werden, indem über eine entsprechende Kommunikation zwischen der Steuerung und der Softwareklemme des Klemmensystems eine auf einer Speichereinheit der Softwareklemme gespeicherte Änderungsanweisung der Steuerung bereitgestellt wird und gemäß der Änderungsanweisung eine entsprechende Änderung der Steuerungssoftware durch die Steuerung bewirkt wird.

Umfasst die Änderungsanweisung die Steuerungssoftware zusätzliche Klemmen des Klemmensystems beziehungsweise spezifische Betriebsparameter dieser Klemmen, so können diese zusätzlichen Teilnehmerklemmen des Klemmensystems durch die Änderung der Steuerungssoftware des Automatisierungssystems auf Basis der Änderungsanweisung der Softwareklemme in das Automatisierungssystem eingefügt werden und mittels der geänderten Steuerungssoftware angesteuert werden.

Somit können durch die Installation des Klemmensystems zusätzliche Geräte in das Automatisierungssystem eingefügt werden. Alternativ können auch bereits im Automatisierungssystem vorhandene Geräte durch neue oder andere Geräte ausgestaucht werden.

Die Erfindung wird im Folgenden anhand von bevorzugten Ausführungsformen näher erläutert. Hierbei zeigen:
- Fig. 1: ein Ablaufdiagramm eines Verfahrens zur Änderung einer Steuerungssoftware eines Automatisierungssystems gemäß einer ersten Ausführungsform;
- Fig. 2: ein Ablaufdiagramm des Verfahrens zur Änderung einer Steuerungssoftware eines Automatisierungssystems gemäß einer weiteren Ausführungsform;
- Fig. 3: eine schematische Darstellung eines Automatisierungssystems gemäß einer ersten Ausführungsform;
- Fig. 4: eine schematische Darstellung eines Automatisierungssystems gemäß einer weiteren Ausführungsform;
- Fig. 5: eine schematische Darstellung einer Softwareklemme gemäß einer Ausführungsform;
- Fig. 6: eine schematische Darstellung einer weiteren Teilnehmerklemme gemäß einer Ausführungsform;
- Fig. 7: eine schematische Darstellung eines Klemmensystems mit einer Softwareklemme und mehreren weiteren Teilnehmerklemmen gemäß einer Ausführungsform;
- Fig. 8: eine schematische Darstellung eines Automatisierungssystems, bei dem das Klemmensystem in Fig. 7 über einen Datenbus mit einer Steuerung des Automatisierungssystems verbunden ist, gemäß einer Ausführungsform; und
- Fig. 9: eine schematische Darstellung eines Automatisierungssystems, bei dem das Klemmensystem in Fig. 7 über einen Datenbus mit einer Steuerung des Automatisierungssystems 300 verbunden ist, gemäß einer weiteren Ausführungsform.

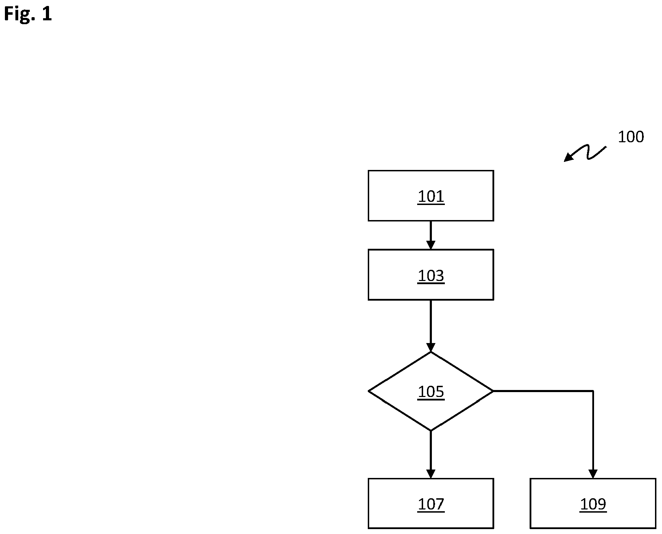

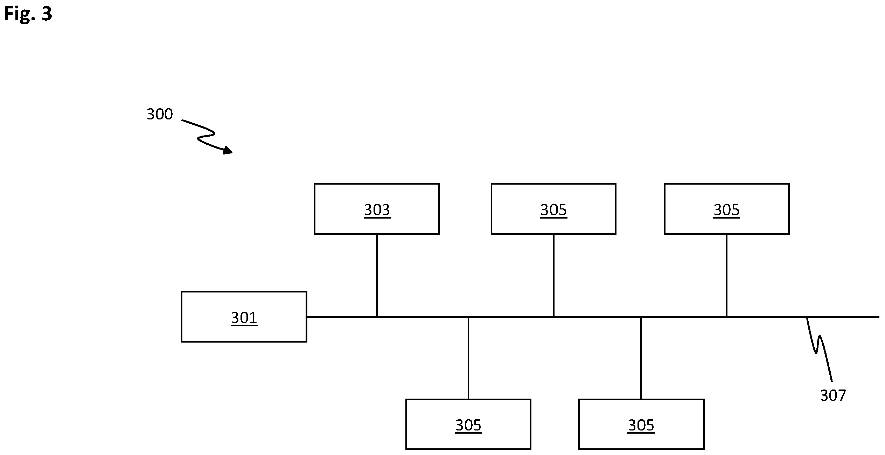

Fig. 1 zeigt ein Ablaufdiagramm eines Verfahrens 100 zur Änderung einer Steuerungssoftware eines Automatisierungssystems gemäß einer ersten Ausführungsform. Zum besseren Verständnis wird das Verfahren stets im Zusammenhang mit dem Aufbau entsprechend Fig. 3, Fig. 4 und Fig. 5 beschrieben.

Das Automatisierungssystem 300 umfasst hierbei eine Steuerung 301 und eine Mehrzahl von Teilnehmern 303, 305, 401, wobei die Teilnehmer 303, 305, 401 über einen Datenbus 307 mit der Steuerung 301 verbunden sind und über einen Datenaustausch kommunizieren.

Ein Teilnehmer 305 ist ein Teilnehmer des Automatisierungssystems 300, der bereits vor Durchführung des Verfahrens 100 zur Änderung einer Steuerungssoftware eines Automatisierungssystems 300 Teilnehmer des Automatisierungssystems 300 war.

Ein zusätzlicher Teilnehmer 401 ist ein Teilnehmer, der mit der Durchführung des Verfahrens 100 zur Änderung einer Steuerungssoftware eines Automatisierungssystems 300 in das Automatisierungssystem 300 integrierbar ist, vor Durchführung des Verfahrens 100 zur Änderung einer Steuerungssoftware eines Automatisierungssystems 300 aber kein Teilnehmer des Automatisierungssystems 300 war.

Ein zusätzlicher Teilnehmer 401 ist kein Software-Teilnehmer 303. Ein zusätzlicher Teilnehmer 401 kann Geräte des Automatisierungssystems 300, wie beispielsweise Aktoren, Sensoren, Motoren oder andere Geräte umfassen.

Ein Software-Teilnehmer 303 ist ein Teilnehmer des Automatisierungssystems 300, der zum Ändern einer Steuerungssoftware der Steuerung 301 dient und eine Speichereinheit umfasst, auf der wenigstens eine Änderungsanweisung zur Änderung der Steuerungssoftware des Automatisierungssystems 300 abgespeichert ist.

Ein Datenbus 307 kann über ein Feldbussystem realisiert sein. Ein solches Feldbussystem kann beziehungsweise können beispielsweise EtherCAT, Ethernet, Profibus oder vergleichbare Feldbussysteme sein.

Das Verfahren 100 umfasst die folgenden Schritte:
Senden einer individuellen Abfragenachricht durch die Steuerung 301 an den Software-Teilnehmer 303 zur Abfrage der wenigstens einen Änderungsanweisung zur Änderung der Steuerungssoftware in einem Abfrageschritt 101;
Senden einer Antwortnachricht durch den Software-Teilnehmer 303 an die Steuerung 301 zum Bereitstellen der wenigstens einen Änderungsanweisung zur Änderung der Steuerungssoftware in einem ersten Antwortschritt 103;
Überprüfen der wenigstens einen Änderungsanweisung zur Änderung der Steuerungssoftware durch die Steuerung 301, ob die Änderungsanweisung mit der Steuerungssoftware kompatibel ist, in einem Überprüfungsschritt 105;
Ändern der Steuerungssoftware gemäß der Änderungsanweisung durch die Steuerung 301 in einem Änderungsschritt 107, wenn die Änderungsanweisung mit der Steuerungssoftware kompatibel ist; und
Verwerfen der Änderungsanweisung durch die Steuerung 301 in einem Verwerfungsschritt 109, wenn die Änderungsanweisung mit der Steuerungssoftware nicht kompatibel ist.

Die Steuerung 301 erkennt den Software-Teilnehmer 303 unter allen Teilnehmern des Automatisierungssystems 300 als einen Teilnehmer, der zur Änderung der Steuerungssoftware dient. Hierauf basierend sendet die Steuerung 301 in einem Abfrageschritt 101 eine individuelle Abfragenachricht an den Software-Teilnehmer 303, um diesen dazu zu bewegen, die auf einer Speichereinheit 501 des Software-Teilnehmers 303 gespeicherte Änderungsanweisung zur Änderung der Steuerungssoftware bereitzustellen.

Darauffolgend sendet der Software-Teilnehmer 303 in einem ersten Antwortschritt 103 eine Antwortnachricht an die Steuerung 301. Die Antwortnachricht des Software-Teilnehmers 303 umfasst hierbei die Änderungsanweisung zur Änderung der Steuerungssoftware, die auf der Speichereinheit 501 des Software-Teilnehmers 303 gespeichert ist. Hierzu umfasst der Software-Teilnehmer 303 eine Anschalteinheit 503, mittels der der Software-Teilnehmer 303 mit der Steuerung 301 über den Datenbus 307 kommunizieren kann.

Alternativ kann auf der Speichereinheit 501 des Software-Teilnehmers 303 auch eine Mehrzahl von Änderungsanweisungen zur Änderung der Steuerungssoftware gespeichert sein. In einem solchem Fall kann der Software-Teilnehmer 303 die Gesamtheit der Mehrzahl von Änderungsanweisungen zur Änderung der Steuerungssoftware in einer einzigen Antwortnachricht an die Steuerung 301 übermitteln.

Alternativ kann die Mehrzahl von Änderungsanweisungen jeweils einzeln in einer Mehrzahl von Antwortnachrichten an die Steuerung 301 übermittelt werden. Wahlweise können auch einzelne Änderungsanweisungen durch entsprechende individuelle Abfragenachrichten durch die Steuerung 301 nacheinander angefordert werden.

Eine Änderungsanweisung zur Änderung der Steuerungssoftware kann beispielsweise ein Update oder eine neue Version der Steuerungssoftware umfassen. Alternativ kann eine Änderungsanweisung ebenfalls eine Modifikation beziehungsweise eine Korrektur möglicher Fehlfunktionen der Steuerungssoftware umfassen.

Darüber hinaus kann eine Änderungsanweisung zur Änderung der Steuerungssoftware eine Steuerungssoftware eines bislang nicht in das Automatisierungssystem 300 integrierten zusätzlichen Teilnehmers 401 sein. In diesem Fall kann die Änderungsanweisung zusätzlich spezifische Betriebsparameter eines solchen zusätzlichen Teilnehmers 401 beziehungsweise weitere Identifizierungskennungen des zusätzlichen Teilnehmers 401 umfassen.

Solche Identifizierungskennungen können beispielsweise den Typ des jeweiligen zusätzlichen Teilnehmers 401 beschreiben. So kann ein zusätzlicher Teilnehmer 401 beispielsweise einen Aktor, einen Sensor, einen Motor oder ein sonstiges Gerät für ein Automatisierungssystem umfassen. Die spezifischen Betriebsparameter können hierbei einen Einsatz- beziehungsweise Belastungsbereich und/oder einen bevorzugten Betriebsbereich und weitere Informationen des jeweiligen zusätzlichen Teilnehmers 401 umfassen.

Zusätzlich kann eine Änderungsanweisung zur Änderung Steuerungssoftware eine Lizensierung der Steuerungssoftware eines Teilnehmers 305, 401 umfassen. Durch die Lizensierung der Steuerungssoftware kann gewährleistet werden, dass ausschließlich Teilnehmer in das Automatisierungssystem 300 aufgenommen sind, die über die passende Steuerungssoftware betrieben werden und die gewünschten Qualitäts- beziehungsweise Sicherungsanforderungen des Automatisierungssystems entsprechen.

Nach Empfang der Änderungsanweisung zur Änderung der Steuerungssoftware durch die Steuerung 301 überprüft die Steuerung 301 in einem Überprüfungsschritt 105 die Änderungsanweisung dahingehend, ob die gemäß der Änderungsanweisung gewünschte Änderung der Steuerungssoftware mit der bestehenden Steuerungssoftware kompatibel ist.

Beispielsweise überprüft die Steuerung 301, ob das in der Änderungsanweisung enthaltene Update beziehungsweise die neue Version der Steuerungssoftware mit den Anforderungen des Automatisierungssystems 300 übereinstimmt. Hierzu kann beispielsweise überprüft werden, ob die Änderungsanweisung in die bestehende Steuerungssoftware integrierbar ist, oder ob gegebenenfalls weitere Änderungen notwendig sind. So kann überprüft werden, ob die aktuelle Version der Software verwendet wird. Es kann überprüft werden, ob die richtigen Schnittstellen für die Softwareänderung der Änderungsanweisung vorhanden sind. Auch kann die Herkunft der Änderungsanweisung auf den jeweiligen Hersteller überprüft werden, um sicherzustellen, dass ausschließlich als authentisch signierte Software in der Änderungsanweisung verwendet wird.

Ebenso kann die Steuerung 301 überprüfen, ob die Steuerungssoftware beziehungsweise die spezifischen Betriebsparameter des zusätzlichen Teilnehmers 401 in die bestehende Steuerungssoftware integrierbar sind.

Beispielsweise kann überprüft werden, ob der Aktor, der Sensor, der Motor oder das andere Gerät des zusätzlichen Teilnehmers 401 den Anforderungen des bestehenden Automatisierungssystems 300 entspricht und somit in das Automatisierungssystem 300 als zusätzlicher Teilnehmer aufgenommen werden kann. Es kann beispielsweise überprüft werden, ob der Aktor, der Sensor, der Motor oder das andere Gerät des zusätzlichen Teilnehmers 401 die Eigenschaften aufweist, die für entsprechende Geräte in diesem Bereich des Automatisierungsprozesses vorgesehen sind. Es kann auch überprüft werden, ob das zusätzliche Gerät des zusätzlichen Teilnehmers mit der jeweiligen Konfiguration des Geräts mit anderen Geräten des Automatisierungssystems zusammenpasst.

Abweichend können auch weitere, nicht angeführte Eigenschaften des zusätzlichen Teilnehmers 401 überprüft werden.

Darüber hinaus kann überprüft werden, ob die zugehörige Steuerungssoftware des zusätzlichen Teilnehmers 401 in die bestehende Steuerungssoftware eingefügt werden kann, ohne dass hierbei Fehlfunktionen auftreten beziehungsweise zusätzlicher Programmieraufwand durch geschultes Fachpersonal notwendig werden.

Wird in dem Überprüfungsschritt 105 erkannt, dass die Änderungsanweisung mit der Steuerungssoftware kompatibel ist, ändert die Steuerung 301 in einem Änderungsschritt 107 die bestehende Steuerungssoftware des Automatisierungssystems 300 gemäß der Änderungsanweisung des Software-Teilnehmers 303.

Die Änderung der Steuerungssoftware kann hierbei eine Implementierung des Updates beziehungsweise der neuen Version der Steuerungssoftware umfassen. Alternativ kann die Änderung der Steuerungssoftware eine Implementierung der Steuerungssoftware eines zusätzlichen Teilnehmers 401 beziehungsweise spezifische Betriebsparameter und/oder weitere Identifizierungskennungen des zusätzlichen Teilnehmers 401 umfassen. Ferner kann eine Änderung der Steuerungssoftware eine Implementierung einer Lizensierung der Steuerungssoftware des zusätzlichen Teilnehmers 401 umfassen.

Durch die Implementierung der Steuerungssoftware, der spezifischen Betriebsparameter beziehungsweise der weiteren Identifizierungskennungen des zusätzlichen Teilnehmers 401 in die bestehende Steuerungssoftware des Automatisierungssystems 300 kann der zusätzliche Teilnehmer 401 in das Automatisierungssystem 300 eingefügt werden, sodass der zusätzliche Teilnehmer 401 über die Steuerungssoftware des Automatisierungssystems 300 angesteuert werden kann.

Sollte in dem Überprüfungsschritt 105 durch die Steuerung 301 festgestellt werden, dass die Änderungsanweisung mit der bestehenden Steuerungssoftware des Automatisierungssystems 300 nicht kompatibel ist, wird die Änderungsanweisung in einem Verwerfungsschritt 109 durch die Steuerung 301 verworfen, und eine Änderung der Steuerungssoftware gemäß der Änderungsanweisung findet nicht statt. Zusätzlich kann eine entsprechende Fehlermeldung ausgegeben werden. Des Weiteren kann das Automatisierungssystem 300 in einen Fehlerzustand schalten, um den entsprechenden Fehler zu beheben, sprich den nicht-kompatiblen Software-Teilnehmer 303 auszutauschen.

Die Steuerung 301 des Automatisierungssystems 300 kann beispielsweise ein Steuerungscomputer, ein Steuerungs-PC oder eine serverbasierte Steuerungseinheit sein.

Ein Teilnehmer 305, 401 des Automatisierungssystems 300, der nicht ein Software-Teilnehmer 303 ist, kann beispielsweise einen Aktor, einen Sensor, einen Motor oder ein weiteres Gerät für ein Automatisierungssystem umfassen.

Ein Software-Teilnehmer 303 kann als ein reales Bauteil ausgebildet sein und beispielsweise eine Bus-Klemme umfassen. Ein Teilnehmer 305, 401 des Automatisierungssystems 300, der nicht ein Software-Teilnehmer 303 ist, kann beispielsweise eine E/A-Klemme und ein entsprechendes Gerät für ein Automatisierungssystem umfassen.

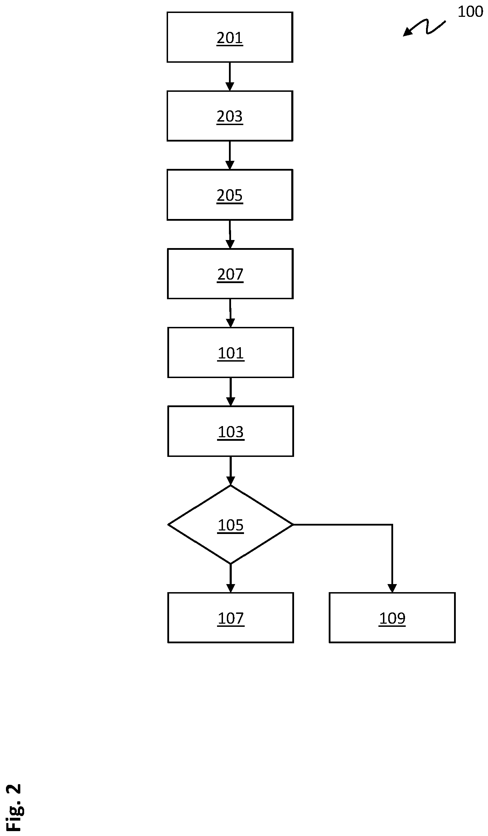

Fig. 2 zeigt ein Ablaufdiagramm des Verfahrens 100 zur Änderung einer Steuerungssoftware eines Automatisierungssystems 300 gemäß einer weiteren Ausführungsform.

Gemäß Fig. 2 umfasst das Verfahren 100 einen Installationsschritt 201, in dem der Software-Teilnehmer 303 in den Datenbus 307 installiert und mit der Steuerung 301 verbunden wird.

Wie oben bereits beschrieben kann der Software-Teilnehmer 303 als ein reales Bauteil ausgebildet sein und beispielsweise eine Bus-Klemme umfassen. Zur Installation des Software-Teilnehmers 303 kann somit der Software-Teilnehmer 303 mit dessen Systemanschlüssen, beispielsweise den Anschlüssen der Bus-Klemme zur Kopplung der Bus-Klemme mit einem Datenbus, an eine entsprechende Datenleitung des Datenbusses 307 verbunden werden.

Über die elektrische Verbindung der jeweiligen Anschlüsse des Software-Teilnehmers 303 mit den entsprechenden Busleitungen des Datenbusses 307 kann eine Verbindung des Software-Teilnehmers 303 mit der Steuerung 301 des Automatisierungssystems hergestellt werden.

Nach Installation des Software-Teilnehmers 303 in den Datenbus 307 und der Verbindung des Software-Teilnehmers 303 mit der Steuerung 301 in dem Installationsschritt 201 sendet die Steuerung 301 in einem weiteren Abfrageschritt 203 eine Identifizierungsabfrage an die Teilnehmer 303, 305, 401 des Automatisierungssystems zur Identifizierung der Teilnehmer 303, 305, 401.

Die Identifizierungsabfrage kann eine allgemeine Abfrage sein, die die Steuerung 301 an alle Teilnehmer des Automatisierungssystems 300 sendet und die dazu dient, die im Automatisierungssystem 300 befindlichen Teilnehmer zu identifizieren. Alternativ kann die Identifizierungsabfrage auch eine individuelle Identifizierungsabfrage sein, die von der Steuerung 301 jeweils an bestimmte Teilnehmer des Automatisierungssystems 300 zur Identifizierung lediglich dieser bestimmten Teilnehmer gesendet wird.

Unter einer Identifizierung eines Teilnehmers des Automatisierungssystems 300 wird im Folgenden eine Kenntnis der jeweiligen Art des Teilnehmers verstanden. Hierzu kann die Identifizierung zunächst das Erkennen umfassen, dass eine in das Automatisierungssystem 300 eingefügte Komponente ein Teilnehmer des Automatisierungssystems 300 ist, der ausgebildet ist, über einen Datenaustausch mit der Steuerung und/oder anderen Teilnehmern zu kommunizieren.

Ferner kann eine Identifizierung eine Information bezüglich der Bauart beziehungsweise der Funktion des jeweiligen Teilnehmers umfassen, beispielsweise ob es sich bei dem jeweiligen Teilnehmer um einen Teilnehmer handelt, der ein Gerät des Automatisierungssystems 300, beispielsweise einen Aktor, einen Sensor, einen Motor oder ein ähnliches Gerät für ein Automatisierungssystem umfasst, oder ob es sich bei dem jeweiligen Teilnehmer um einen Teilnehmer handelt, der wie der Software-Teilnehmer 303 kein Gerät des Automatisierungssystems 300 umfasst, sondern einer weiteren Funktion dient.

Nach Empfang der Identifizierungsabfrage durch die Teilnehmer 303, 305, 401 des Automatisierungssystems 300 sendet der Software-Teilnehmer 303 an die Steuerung 301 in einem zweiten Antwortschritt 205 eine Identifizierungsantwort. In dieser Identifizierungsantwort gibt sich der Software-Teilnehmer 303 als ein Teilnehmer des Automatisierungssystems 300 zu erkennen, der zu Änderung der Steuerungssoftware des Automatisierungssystems 300 dient.

Neben dem Software-Teilnehmer 303 können auch alle weiteren Teilnehmer 305, 401 des Automatisierungssystems 300, die kein Software-Teilnehmer 303 sind, eine Identifizierungsantwort an die Steuerung 301 senden. In den jeweiligen Identifizierungsantworten der Teilnehmer 305, 401, die nicht der Software-Teilnehmer 303 sind, können Informationen enthalten sein bezüglich der Funktion des jeweiligen Teilnehmers in dem Automatisierungssystem 300 beziehungsweise bezüglich der Bauart und Funktion der jeweiligen Geräte des entsprechenden Teilnehmers. Es können auch weitere Informationen enthalten sein.

Nach Empfang der Identifizierungsantwort des Software-Teilnehmers 303 durch die Steuerung 301 identifiziert die Steuerung 301 in einem Identifizierungsschritt 207 den Software-Teilnehmer 303 auf Basis der Identifizierungsantwort des Software-Teilnehmers 303 als einen Teilnehmer zur Änderung der Steuerungssoftware des Automatisierungssystems 300.

Die Identifizierung des Software-Teilnehmers 303 durch die Steuerung 301 kann hierbei einen Abgleich einer Identifizierungskennung des Software-Teilnehmers 303, die in der Identifizierungsantwort des Software-Teilnehmers 303 enthalten ist, mit Identifizierungskennungen, die der Steuerung 301 bekannt sind und beispielsweise in einer entsprechenden Datenbank abgelegt sind, umfassen.

Das Verfahren 100 zur Änderung einer Steuerungssoftware eines Automatisierungssystems 300 gemäß Fig. 1 oder gemäß Fig. 2 kann in einer Startphase des Automatisierungssystems 300, in der das Automatisierungssystem 300 nicht in Betrieb ist, oder in einem laufenden Betrieb des Automatisierungssystems 300 durchgeführt werden.

Beispielsweise kann ein Software-Teilnehmer 303 gemäß dem Installationsschritt 201 in den Datenbus 307 des Automatisierungssystems 300 installiert werden, wenn das Automatisierungssystem 300 nicht betrieben wird und sich in einem ausgeschalteten Zustand befindet. Wird nach Installation des Software-Teilnehmers 303 das Automatisierungssystem 300 gestartet, wird der neu installierte Software-Teilnehmer 303 in einer Initialisierungsphase, in der die Steuerungssoftware aufgefahren wird, von der Steuerung 301 als neuer Teilnehmer des Automatisierungssystems 300 erkannt und gemäß dem weiteren Abfrageschritt 203, dem zweiten Antwortschritt 205 und dem Identifizierungsschritt 207 als ein Teilnehmer identifiziert, der zur Änderung der Steuerungssoftware dient.

Darauffolgend wird die Steuerung 301 gemäß dem Abfrageschritt 101 den Software-Teilnehmer 303 zum Bereitstellen der Änderungsanweisung des Software-Teilnehmers 303 antreiben.

Nach Übersendung der Änderungsanweisung durch den Software-Teilnehmer 303 an die Steuerung 301 gemäß dem ersten Antwortschritt 103 und der Überprüfung der Änderungsanweisung durch die Steuerung 301 gemäß dem Überprüfungsschritt 105 wird die Steuerung 301 die Änderung der Steuerungssoftware gemäß der Änderungsanweisung gemäß dem Änderungsschritt 107 durchführen, wenn die Überprüfung eine Kompatibilität zwischen der gewünschten Änderung und der bestehenden Steuerungssoftware ergeben hat.

Ansonsten wird die Änderungsanweisung durch die Steuerung 301 gemäß dem Verwerfungsschritt 109 verworfen und die Steuerungssoftware unverändert belassen.

Bei Beendigung der Startphase, in der die Steuerungssoftware des Automatisierungssystems 300 initialisiert und die Teilnehmer 303, 305, 401 des Automatisierungssystems 300 in einen betriebsbereiten Zustand versetzt sind, ist eine Änderung der Steuerungssoftware gemäß dem Verfahren 100 zum Ändern einer Steuerungssoftware eines Automatisierungssystems 300 abgeschlossen, sodass das Automatisierungssystem 300 mit geänderter Steuerungssoftware betrieben werden kann.

Alternativ kann das Verfahren 100 zum Ändern einer Steuerungssoftware eines Automatisierungssystems 300 mit den oben genannten Schritten ebenfalls durchgeführt werden, wenn sich das Automatisierungssystem 300 in einem Betriebszustand befindet. Hierzu wird der entsprechende Software-Teilnehmer 303 gemäß dem Installationsschritt 201 in einem Bereich des Automatisierungssystems 300 installiert, der sich zur Zeit der Installation des Software-Teilnehmers 303 in einem Konfigurationszustand befindet und in dem die jeweiligen Teilnehmer dieses Bereichs des Automatisierungssystems 300 nicht betrieben werden.

Hierzu findet eine Identifizierung des Software-Teilnehmers 303 durch die Steuerung 301 gemäß dem weiteren Abfrageschritt 203, dem zweiten Antwortschritt 205 und dem Identifizierungsschritt 207 statt, während die Teilnehmer dieses Bereichs des Automatisierungssystems 300 sich im Konfigurationszustand befinden.

Darauffolgend fordert die Steuerung 301 den Software-Teilnehmer 303 zum Bereitstellen der Änderungsanweisung gemäß dem Abfrageschritt 101 auf.

Nach Bereitstellung der Änderungsanweisung durch den Software-Teilnehmer 303 gemäß dem ersten Antwortschritt 103 überprüft die Steuerung 301 die Änderungsanweisung hinsichtlich Kompatibilität der Änderungsanweisung mit der bestehenden Steuerungssoftware gemäß dem Überprüfungsschritt 105 und ändert die Steuerungssoftware gemäß der Änderungsanweisung im Änderungsschritt 107, wenn die Änderungsanweisung mit der Steuerungssoftware kompatibel ist.

Die Änderung der Steuerungssoftware gemäß dem Verfahren 100 zum Ändern einer Steuerungssoftware eines Automatisierungssystems 300 ist somit abgeschlossen, bevor die Konfigurationsaufgaben der Steuerung 301 beendet sind und der entsprechende Teil des Automatisierungssystems aus dem Konfigurationszustand in einen Betriebszustand versetzt wird.

Die entsprechenden Teilnehmer 303, 305, 401 des entsprechenden Bereichs des Automatisierungssystems 300 können somit nach Beendigung des Konfigurationszustands mit geänderter Steuerungssoftware betrieben werden.

Gemäß einer Ausführungsform kann die Änderung der Steuerungssoftware gemäß der Änderungsanweisung des Software-Teilnehmers 303 ein Einpflegen wenigstens eines zusätzlichen Teilnehmers 401, der nicht der Software-Teilnehmer 303 ist, in den Datenbus 307 des Automatisierungssystems 300 umfassen.

Hierzu kann in dem Installationsschritt 201 neben dem Software-Teilnehmer 303 ein zusätzlicher Teilnehmer 401 in den Datenbus 307 installiert und mit der Steuerung 301 verbunden werden. Ein solcher zusätzlicher Teilnehmer 401 kann beispielsweise eine E/A-Klemme und ein Gerät für ein Automatisierungssystem, wie einen Aktor, einen Sensor, einen Motor oder ein ähnliches Gerät umfassen. Zur Installation dieses zusätzlichen Teilnehmers 401 kann somit die entsprechende E/A-Klemme mit den jeweiligen Anschlüssen an die Datenleitungen des Datenbusses 307 angeschlossen werden.

In einem solchen Fall kann die Änderungsanweisung des Software-Teilnehmers 303 eine Steuerungssoftware des zusätzlichen Teilnehmers 401, spezifische Betriebsparameter des zusätzlichen Teilnehmers 401, individuelle Identifizierungskennungen des zusätzlichen Teilnehmers 401, eine Lizensierung der Steuerungssoftware des zusätzlichen Teilnehmers 401 und weitere Informationen bezüglich des zusätzlichen Teilnehmers 401 umfassen.

Nach Installation des Software-Teilnehmers 303 und des zusätzlichen Teilnehmers 401 gemäß dem Installationsschritt 201 sendet die Steuerung 301 eine Identifizierungsabfrage an die Teilnehmer 303, 305, 401, insbesondere an den Software-Teilnehmer 303 und den zusätzlichen Teilnehmer 401, in dem weiteren Abfrageschritt 203.

Darauffolgend sendet der Software-Teilnehmer 303 eine Identifizierungsantwort an die Steuerung 301 in dem zweiten Antwortschritt 205. Die Identifizierungsantwort umfasst eine Identifizierungsinformation bezüglich des Software-Teilnehmers 303, die den Software-Teilnehmer 303 als einen Teilnehmer identifiziert, der zur Änderung der Steuerungssoftware des Automatisierungssystems 300 dient.

Die Identifizierungsantwort des Software-Teilnehmers 303 umfasst darüber hinaus eine Identifizierungsinformation bezüglich des zusätzlichen Teilnehmers 401, die auf der Speichereinheit 501 des Software-Teilnehmers gespeichert sein kann.

Aufgrund der Identifizierungsantwort des Software-Teilnehmers 303 identifiziert die Steuerung 301 den Software-Teilnehmer 303 als einen Teilnehmer zur Änderung der Steuerungssoftware in dem Identifizierungsschritt 207. Zusätzlich identifiziert die Steuerung 301 in dem Identifizierungsschritt 207 auf Basis der Identifizierungsantwort des Software-Teilnehmers 303 den zusätzlichen Teilnehmer 401 als einen Teilnehmer, dessen Steuerungssoftware, spezifische Betriebsparameter, weitere Identifizierungskennungen und zusätzliche Informationen als Änderungsanweisung durch den Software-Teilnehmer 303 bereitgestellt werden.

Darauffolgend sendet in einem Abfrageschritt 101 die Steuerung 301 eine individuelle Abfragenachricht an den Software-Teilnehmer 303 zur Abfrage der Änderungsanweisung zur Änderung der Steuerungssoftware.

In dem darauffolgenden ersten Antwortschritt 103 sendet der Software-Teilnehmer 303 die Änderungsanweisung an die Steuerung 301. Wie bereits erwähnt, umfasst die Änderungsanweisung in diesem Fall die Steuerungssoftware des zusätzlichen Teilnehmers 401, spezifische Betriebsparameter des zusätzlichen Teilnehmers 401, weitere Identifizierungskennungen des zusätzlichen Teilnehmers 401, eine Lizensierung der Steuerungssoftware des zusätzlichen Teilnehmers 401 und weitere Informationen bezüglich des zusätzlichen Teilnehmers 401 an die Steuerung 301.

Darauffolgend überprüft die Steuerung 301 die Kompatibilität der Änderungsanweisung in dem Überprüfungsschritt 105. Diesbezüglich kann von der Steuerung 301 überprüft werden, ob der zusätzliche Teilnehmer 401 in das bereits bestehende Automatisierungssystem 300 eingefügt werden kann.

Beispielsweise überprüft die Steuerung 301 die Funktion des zusätzlichen Teilnehmers 401 beziehungsweise, ob der zusätzliche Teilnehmer 401 ein Gerät umfasst, das beispielsweise ein Aktor, ein Sensor, oder ein Motor sein kann, und inwiefern dieses Gerät in das bestehende Automatisierungssystem 300 passt.

Ferner überprüft die Steuerung 301 in diesem Zusammenhang die spezifischen Betriebsparameter des zusätzlichen Teilnehmers 401, ob der zusätzliche Teilnehmer 401 diesbezüglich die Vorgaben des bestehenden Automatisierungssystems 300 erfüllt. Es wird beispielsweise überprüft, ob die Hardware, insbesondere die Geräte, des zusätzlichen Teilnehmers 401 an der entsprechenden Stelle in das bestehende Automatisierungssystem 300 eingefügt werden kann, ohne dass diese oder andere Geräte des Automatisierungssystems 300 beschädigt werden. Hierzu kann überprüft werden, ob die Betriebsdaten der jeweiligen Geräte mit dem von der Steuerung für diese Geräte vorgesehenen Grenzbereichen liegt.

Beispielsweise kann überprüft werden, ob die Drehzahl eines Motors eines zusätzlichen Teilnehmers 401 in dem Drehzahlbereich liegt, der für Motoren vorgesehen ist, die in diesem bestimmten Bereich des Automatisierungssystems verbaut werden sollen. Die Erfindung soll nicht hierauf beschränkt werden.

Ferner kann überprüft werden, ob die für den Betrieb der zusätzlichen Teilnehmer 401 benötigte Rechenleistung der Steuerung 301 des Automatisierungssystems 300 zur Verfügung steht.

Erkennt die Steuerung 301 in dem Überprüfungsschritt 105 eine Kompatibilität der Änderungsanweisung mit der Steuerungssoftware, ändert die Steuerung 301 in dem Änderungsschritt 107 die Steuerungssoftware gemäß der Änderungsanweisung. Hiermit ist der zusätzliche Teilnehmer 401 in das Automatisierungssystem 300 eingefügt und kann von nun an von der Steuerung 301 individuell angesteuert werden.

Unter Berücksichtigung der Lizensierung der Steuerungssoftware des zusätzlichen Teilnehmers 401 kann gewährleistet werden, dass ausschließlich zusätzliche Teilnehmer 401 in das Automatisierungssystem 300 eingefügt werden, die entsprechenden Qualitäts- und Sicherheitsanforderungen entsprechen.

Nach Änderung der Steuerungssoftware gemäß der Änderungsanweisung und der Installation des zusätzlichen Teilnehmers 401 kann das Automatisierungssystem 300 mit geänderter Steuerungssoftware und dem zusätzlichen Teilnehmer 401 betrieben werden.

Zusätzlich kann auch eine Mehrzahl von zusätzlichen Teilnehmern 401 mit den oben beschriebenen Schritten in das Automatisierungssystem 300 eingefügt werden. In diesem Fall kann die Änderungsanweisung des Software-Teilnehmers 303 die Steuerungssoftware, spezifische Betriebsparameter, Identifizierungskennungen, Lizensierungen der Steuerungssoftware und andere spezifische Informationen der Mehrzahl von zusätzlichen Teilnehmern 401 umfassen.

Alternativ können auch eine Mehrzahl von Änderungsanweisungen auf der Speichereinheit 501 des Software-Teilnehmers 303 gespeichert sein, wobei jede Änderungsanweisung Informationen bezüglich eines zusätzlichen Teilnehmers 401 umfasst.

Alternativ können auch eine Mehrzahl von Software-Teilnehmern 303, von denen jeder eine Änderungsanweisung mit Informationen bezüglich lediglich eines zusätzlichen Teilnehmers 401 umfasst, in das Automatisierungssystem 300 eingefügt werden.

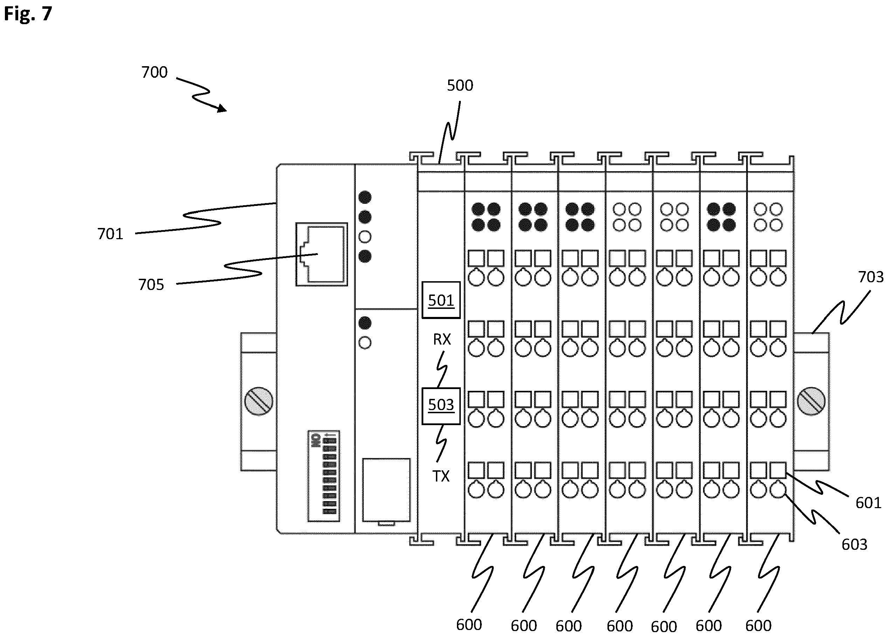

Die Mehrzahl von zusätzlichen Teilnehmern 401 können beispielsweise zusammen mit dem Software-Teilnehmer 303, oder mit mehreren Software-Teilnehmern 303, zu einem Klemmensystem 700, wie beispielsweise in Fig. 7 dargestellt, zusammengefasst werden.

Nach Installation der Mehrzahl von zusätzlichen Teilnehmern 401 in das Automatisierungssystem 300 und der entsprechenden Änderung der Steuerungssoftware gemäß den oben beschriebenen Schritten kann jeder der Mehrzahl von zusätzlichen Teilnehmern 401 durch die Steuerung 301 individuell angesteuert werden.

Fig. 3 zeigt eine schematische Darstellung eines Automatisierungssystems 300 gemäß einer ersten Ausführungsform.

Das Automatisierungssystem 300 in Fig. 3 umfasst eine Steuerung 301 und eine Mehrzahl von Teilnehmern 305, die über einen Datenbus 307 miteinander und mit der Steuerung 301 verbunden sind. Darüber hinaus umfasst das Automatisierungssystem 300 einen Software-Teilnehmer 303, der mit den Teilnehmern 305 und der Steuerung 301 über den Datenbus 307 verbunden ist.

Ein Teilnehmer 305 ist ein Teilnehmer des Automatisierungssystems 300, der bereits vor Durchführung des Verfahrens 100 zur Änderung einer Steuerungssoftware eines Automatisierungssystems 300 Teil des Automatisierungssystems 300 war und der nicht ein Software-Teilnehmer 303 ist.

Ein Teilnehmer 305 gemäß Fig. 3 kann beispielsweise Geräte, wie Aktoren, Sensoren oder Motoren, des Automatisierungssystems 300 umfassen.

Ein Software-Teilnehmer 303 dient zum Ändern einer Steuerungssoftware der Steuerung 301 und umfasst eine Speichereinheit, auf der wenigstens eine Änderungsanweisung zur Änderung der Steuerungssoftware des Automatisierungssystems 300 abgespeichert ist. Der Software-Teilnehmer 303 wird von der Steuerung 301 als ein Teilnehmer des Automatisierungssystems 300 erkannt und ist somit ein gleichwertiger Teilnehmer. Der Software-Teilnehmer 303 kann aber ausgebildet sein, ausschließlich zur Änderung der Steuerungssoftware zu dienen, ohne weitere Funktion innerhalb des Automatisierungssystems aufzuweisen.

Das in Fig. 3 gezeigte Automatisierungssystem 300 ist ausgebildet, das Verfahren 100 zur Änderung der Steuerungssoftware eines Automatisierungssystems 300 mit den oben beschriebenen Schritten durchzuführen.

In der Ausführungsform in Fig. 3 wird kein zusätzlicher Teilnehmer 401 in das Automatisierungssystem 300 eingefügt.

Ein zusätzlicher Teilnehmer 401 ist ein Teilnehmer, der mit der Durchführung des Verfahrens 100 zur Änderung einer Steuerungssoftware eines Automatisierungssystems 300 in das Automatisierungssystem 300 integrierbar ist, vor Durchführung des Verfahrens 100 zur Änderung einer Steuerungssoftware eines Automatisierungssystems 300 aber kein Teilnehmer des Automatisierungssystems 300 war.

Die Änderungsanweisung des Software-Teilnehmers 303 umfasst somit ausschließlich Änderungen der bestehenden Steuerungssoftware des Automatisierungssystems 300. Diese Änderungen können beispielsweise ein Update, eine neuere Fassung der Steuerungssoftware oder Modifikationen beziehungsweise Korrekturen bestehender Fehlfunktionen der Steuerungssoftware umfassen.

Die in Fig. 3 gezeigte Topologie des Automatisierungssystems 300 ist lediglich zu Illustrationszwecken aufgrund ihrer einfachen Darstellbarkeit gewählt. Das Automatisierungssystem 300 kann ebenfalls eine anders geartete Topologie aufweisen. Ebenfalls kann der Software-Teilnehmer 303 an einer anderen Stelle im Automatisierungssystem 300 angeordnet sein. Es können auch mehrere Software-Teilnehmer 303 in das Automatisierungssystem 300 integriert sein.

Die Steuerung 301 ist ausgebildet, eine Abfragenachricht gemäß dem Abfrageschritt 101 an den Software-Teilnehmer 303 zu senden. Der Software-Teilnehmer 303 ist ausgebildet, eine entsprechende Antwortnachricht gemäß dem ersten Antwortschritt 103 an die Steuerung 301 zum Bereitstellen der wenigstens einen Änderungsanweisung zu senden. Die Steuerung 301 ist wiederum ausgebildet, die Änderungsanweisung des Software-Teilnehmers 303 gemäß dem Überprüfungsschritt 105 zu überprüfen und die Steuerungssoftware in einem Änderungsschritt 107 gemäß der Änderungsanweisung zu ändern, wenn die Änderungsanweisung mit der Steuerungssoftware kompatibel ist. Ansonsten ist die Steuerung 301 ausgebildet, die Änderungsanweisung gemäß dem Verwerfungsschritt 109 zu verwerfen und eine Änderung der Steuerungssoftware zu unterlassen.

Die Steuerung 301 ist ferner ausgebildet, eine Identifizierungsabfrage an die Teilnehmer 303, 305 des Automatisierungssystems 300 gemäß des zweiten Abfrageschritts 203 zu senden. Der Software-Teilnehmer 303 ist wiederum ausgebildet, eine Identifizierungsantwort gemäß dem zweiten Antwortschritt 205 an die Steuerung 301 zu senden. Die Steuerung 301 ist wiederum ausgebildet, den Software-Teilnehmer 303 auf Basis der Identifizierungsantwort gemäß dem Identifizierungsschritt 207 zu identifizieren.

Darüber hinaus können die Steuerung 301 und der Software-Teilnehmer 303 ausgebildet sein, eine Änderung der Steuerungssoftware gemäß dem Verfahren 100 zur Änderung der Steuerungssoftware eines Automatisierungssystems 300 während einer Startphase des Automatisierungssystems 300 oder im laufenden Betrieb des Automatisierungssystems 300 durchzuführen.

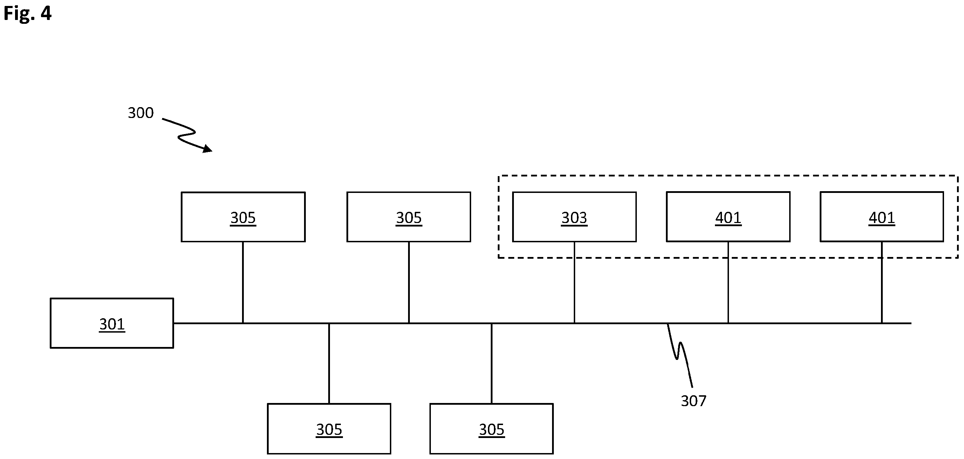

Fig. 4 zeigt eine schematische Darstellung eines Automatisierungssystems 300 gemäß einer weiteren Ausführungsform.

Im Unterschied zu dem Automatisierungssystem 300 der Fig. 3 umfasst das Automatisierungssystem 300 der Fig. 4 zusätzliche Teilnehmer 401. Die zusätzlichen Teilnehmer 401 sind hintereinander nach einem Software-Teilnehmer 303 angeordnet. Mittels des gestrichelten Kastens ist verdeutlicht, dass der Software-Teilnehmer 303 und die jeweiligen zusätzlichen Teilnehmer 401 derart miteinander in Verbindung stehen, dass der Software-Teilnehmer 303 die entsprechenden Änderungsanweisungen für die jeweiligen zusätzlichen Teilnehmer 401 aufweist.

Gemäß dem oben beschriebenen Verfahren 100 zur Änderung einer Steuerungssoftware eines Automatisierungssystems 300 können die zusätzlichen Teilnehmer 401 über eine entsprechende Änderungsanweisung des Software-Teilnehmers 303 in das Automatisierungssystems 300 eingefügt werden.

Hierzu umfasst die Änderungsanweisung des Software-Teilnehmers 303 die Steuerungssoftware, spezifische Betriebsparameter, mögliche Lizensierungen der Steuerungssoftware, weitere Identifizierungs- und zusätzliche Informationen der zusätzlichen Teilnehmer 401.

Die Datenübertragung beziehungsweise die Kommunikation zwischen der Steuerung 301 und den Teilnehmern 303, 305, 401 des Automatisierungssystems 300 kann beispielsweise auf einem Feldbussystem basieren.

Dies kann beispielsweise ein EtherCAT-System oder ein ähnliches System sein, bei dem die Steuerung 301 als ein Master und die einzelnen Teilnehmer 303, 305, 401 als Slaves fungieren, bei dem ausschließlich der Master ausgebildet ist, Abfragenachrichten an die Slaves auszusenden, und die Slaves ausschließlich ausgebildet sind, auf diese Abfragenachrichten mit entsprechenden Antwortnachrichten zu antworten.

Die Datenkommunikation zwischen dem Master und den Slaves kann hierbei über den Austausch von Telegrammen eines Feldbusprotokolls, beispielsweise EtherCAT, realisiert werden. Derartige Telegramme können sowohl Abfragenachrichten beziehungsweise Funktionsanweisungen des Masters an eine Mehrzahl der Teilnehmer 303, 305, 401 des Automatisierungssystems 300 oder auch individuelle Abfragenachrichten beziehungsweise Funktionsanweisungen an einzelne Teilnehmer des Automatisierungssystems 300 umfassen.

Die Teilnehmer 303, 305, 401 des Automatisierungssystems 300 können hierzu jeweils eine Empfangseinheit Rx und Sendeeinheit Tx aufweisen, die jeweils zum Empfangen und zum Aussenden der Telegramme dienen. Vorzugsweise kann ein Telegramm von der Steuerung 301 des Automatisierungssystems 300 an die Teilnehmer 303, 305, 401 ausgesendet werden, indem der erste Teilnehmer, der eine kürzeste Distanz zur Steuerung 301 aufweist, mittels dessen Empfangseinheit Rx das entsprechende Telegramm empfängt und mittels dessen Sendeeinheit Tx an den jeweils nächsten Teilnehmer übermittelt.

Der jeweils nächste Teilnehmer empfängt das Telegramm vom jeweils vorangegangenen Teilnehmer mit dessen Empfangseinheit Rx und sendet das Telegramm mit dessen Sendeeinheit Tx an den wiederum jeweils nächsten Teilnehmer. Der letzte Teilnehmer wiederum empfängt das Telegramm von dem vorangegangenen Teilnehmer und sendet das Telegramm zurück zur Steuerung 301.

Somit kann ein Telegramm vor dem Zurücksenden an die Steuerung 301 alle Teilnehmer 303, 305, 401 des Automatisierungssystems 300 durchlaufen.

Jeder der Teilnehmer 303, 305, 401 kann bei Empfang des Telegramms durch dessen Anschalteinheit 503 dem empfangenen Telegramm die an den jeweiligen Teilnehmer gerichtete Abfragenachricht beziehungsweise Funktionsanweisung entnehmen, die entsprechende Funktion durchführen oder eine entsprechende Antwortnachricht in das Telegramm einfügen und dieses mittels der Sendeeinheit Tx an den jeweils nächsten Teilnehmer übermitteln.

Nachdem alle Teilnehmer das Telegramm empfangen haben und die jeweils an sie gerichtete Funktionsanweisung ausgeführt beziehungsweise die an sie gerichtete Abfragenachricht mit einer entsprechenden Antwortnachricht beantwortet und diese Antwortnachricht in das Telegramm eingebunden haben, kann der letzte Teilnehmer das bearbeitete Telegramm an die Steuerung 301 zurücksenden.

Das Automatisierungssystem 300 mit der Steuerung 301 und den Teilnehmern 303, 305, 401 kann somit durch das wie oben beschriebene Aussenden von Telegrammen durch die Steuerung 301 an die Teilnehmer 303, 305, 401 das Verfahren 100 zur Änderung einer Steuerungssoftware eines Automatisierungssystems 300 ausführen, indem die Steuerung die Abfragenachrichten gemäß dem Abfrageschritt 101 und dem weiteren Abfrageschritt 203 in entsprechende Telegramme einbindet, an die Teilnehmer 303, 305, 401 aussendet, und die jeweils durch die Abfragenachrichten angesprochenen Teilnehmer 303, 305, 401 die entsprechenden Antwortnachrichten gemäß dem ersten Antwortschritt 103 und dem zweiten Antwortschritt 205 in das jeweilige Telegramm einbinden. Die Antwortnachrichten der Teilnehmer, die diese in das Telegramm einbinden, können vorliegend auch Messdaten eines entsprechenden Geräts des jeweiligen Teilnehmers 305, 401 umfassen.

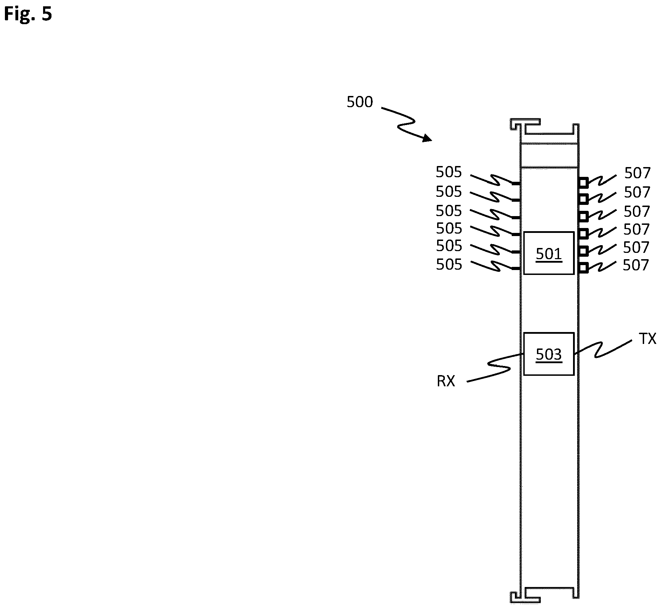

Fig. 5 zeigt eine schematische Darstellung einer Softwareklemme 500 gemäß einer Ausführungsform.

In Fig. 5 ist der Software-Teilnehmer 303 des Automatisierungssystems 300, der wie oben beschrieben im Verfahren 100 zur Änderung einer Steuerungssoftware eines Automatisierungssystems 300 beziehungsweise in dem oben beschriebenen Automatisierungssystem 300 zur Änderung der Steuerungssoftware des Automatisierungssystems 300 dient, als eine Softwareklemme 500, insbesondere als eine Bus-Klemme ausgebildet.

Die Softwareklemme 500 umfasst eine Speichereinheit 501 und eine Anschalteinheit 503. Die Speichereinheit 501 dient zur Speicherung der Änderungsanweisungen zur Änderung der Steuerungssoftware des Automatisierungssystems 300. Die Speichereinheit 501 kann ausgebildet sein, eine Vielzahl von Änderungsanweisungen zu speichern.

Darüber hinaus kann die Speichereinheit 501 ausgebildet sein, mehrfach überschreibbar zu sein, sodass mehrere verschiedene Änderungsanweisungen nacheinander auf der Speichereinheit 501 gespeichert werden können. Somit kann die Softwareklemme 500 für verschiedene Änderungen der Steuerungssoftware eines Automatisierungssystems 300 verwendet werden.

Die Anschalteinheit 503 dient dazu, eine Kommunikation mit einer Steuerung 301 beziehungsweise weiteren Teilnehmern 305, 401 eines Automatisierungssystems 300 bereitzustellen. Die Anschalteinheit 503 kann eine Empfangseinheit Rx und eine Sendeeinheit Tx aufweisen und somit das Empfangen beziehungsweise das Aussenden von Telegrammen ermöglichen.

Darüber hinaus kann die Anschalteinheit 503 ausgebildet sein, empfangene Abfragenachrichten der Steuerung 301, beispielsweise eingebunden in entsprechende Telegramme, auszulesen und entsprechende Antwortnachrichten auszusenden, beziehungsweise in jeweilige Telegramme einzubinden.

Die Kommunikation der Softwareklemme 500 mit anderen Teilnehmern oder Klemmen des Automatisierungssystems 300 kann auch über erste Anschlüsse 505 und zweite Anschlüsse 507 realisiert werden, mittels derer die Softwareklemme 500 mit entsprechenden Busleitungen des Datenbusses 307 beziehungsweise entsprechenden Anschlüssen weiterer Bus-Klemmen verbunden werden kann.

Die Softwareklemme 500 kann als eine handelsübliche Bus-Klemme, beispielsweise als eine EtherCAT-Klemme, ausgestaltet sein, sodass die Softwareklemme 500 in einem Datenbus 307 eines Automatisierungssystems 300 eingebunden werden kann und darüber hinaus mit weiteren Bus-Klemmen des Automatisierungssystems verbunden und beispielsweise zu einem Klemmensystem zusammengefügt werden kann.

Die Softwareklemme 500 kann weiter eine Rasteinheit (nicht gezeigt) aufweisen, mittels welcher die Softwareklemme 500 über eine entsprechende Tragschiene verrasten kann und mit weiteren Teilnehmerklemmen zu einem Klemmensystem verbunden werden kann.

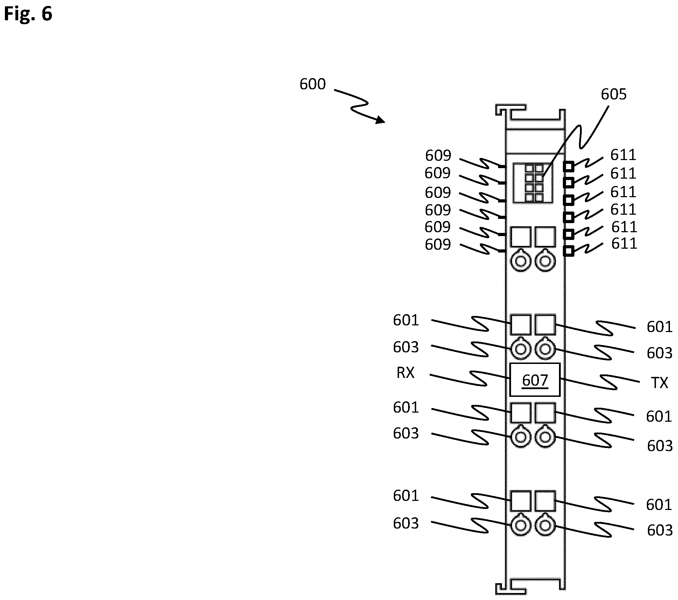

Fig. 6 zeigt eine schematische Darstellung einer weiteren Teilnehmerklemme 600 gemäß einer Ausführungsform.

Die Teilnehmer 305, 401 des Automatisierungssystems 300, die nicht ein Software-Teilnehmer 303 sind, können jeweils eine Teilnehmerklemme 600 umfassen. Die Teilnehmerklemme 600 kann strukturell im Wesentlichen analog zu der Softwareklemme 500 aufgebaut sein. Im Gegensatz zur Softwareklemme 500 sind die weiteren Teilnehmerklemmen 600 der Teilnehmer 305, 401 jedoch als E/A-Klemmen (Eingangs-/Ausgangs-Klemmen) ausgebildet und weisen zusätzlich jeweils Anschlusseinrichtungen 601 mit mehreren Anschlussöffnungen 603 zum Anschließen von Geräten des Automatisierungssystems 300 auf. Solche Geräte der Teilnehmer 305, 401 können beispielsweise Aktoren, Sensoren, Motoren oder weitere Geräte für ein Automatisierungssystem sein.

Die Teilnehmerklemme 600 weist ferner eine zweite Anschalteinheit 607 auf, mittels welcher die Teilnehmerklemme 600 über eine Datenübertragung mit der Steuerung 301 beziehungsweise anderen Teilnehmern des Automatisierungssystems 300 kommunizieren kann. Die zweite Anschalteinheit 607 umfasst eine Empfangseinheit Rx und eine Sendeeinheit Tx zum Empfangen und Aussenden von Busprotokollen, beispielsweise von Telegrammen.

Die zweite Anschalteinheit 607 ist somit in der Lage, von der Steuerung 301 ausgesendete Telegramme zu empfangen, diese auszulesen, das entsprechende an die jeweilige Teilnehmerklemme 600 angeschlossene Gerät mit der jeweiligen Nachricht des empfangenen Telegramms anzutreiben und gegebenenfalls Messdaten oder weitere Parameter des jeweiligen Geräts als Antwortnachricht in das entsprechende Telegramm einzufügen und dieses an den jeweils nächsten Teilnehmer beziehungsweise an die Steuerung 301 des Automatisierungssystems 300 zu senden.

Die Teilnehmerklemme 600 umfasst ferner dritte Anschlüsse 609 und vierte Anschlüsse 611, mittels derer die Teilnehmerklemme 600 an entsprechende Busleitungen eines Datenbusses 307 angeschlossen werden kann. Über die dritten Anschlüsse 609 und die vierten Anschlüsse 611 kann die Teilnehmerklemme 600 ferner mit weiteren Klemmen, beispielsweise einer Softwareklemme 500, verbunden und zu einem Klemmensystem zusammengefügt werden.

Die Teilnehmerklemme 600 weist ferner eine nicht gezeigte Rasteinheit auf, mit der die Teilnehmerklemme 600 an einer Tragschiene verrasten und somit mit weiteren Klemmen zu einem Klemmensystem zusammengefügt werden kann.

Die Teilnehmerklemme 600 umfasst ferner eine Anzeigeeinrichtung 605, mittels welcher ein Betriebszustand der Teilnehmerklemme 600 beziehungsweise des an die Teilnehmerklemme 600 angeschlossenen Geräts angezeigt werden kann.

Die in Fig. 5 und Fig. 6 gezeigte Ausgestaltung der Softwareklemme 500 und der Teilnehmerklemme 600 dient lediglich als eine beispielhafte Darstellung und ist nicht als einschränkend zu verstehen.

Fig. 7 zeigt eine schematische Darstellung eines Klemmensystems 700 mit einer Softwareklemme 500 und mehreren Teilnehmerklemmen 600 gemäß einer Ausführungsform.

Das Klemmensystem 700 in Fig. 7 umfasst eine Softwareklemme 500 und sechs Teilnehmerklemmen 600, die auf einer Tragschiene 703 zu dem Klemmensystem 700 zusammengefügt sind. Das Klemmensystem 700 umfasst ferner einen Buskoppler 701, der ebenfalls an der Tragschiene 703 angebracht ist.

Die Teilnehmerklemmen 600 sind als E/A-Klemmen ausgebildet und weisen eine Mehrzahl von Anschlusseinrichtungen 601 mit entsprechenden Anschlussöffnungen 603 auf. Vorliegend sind aus Gründen der Übersichtlichkeit nicht alle Merkmale der Teilnehmerklemmen 600 dargestellt.

Die Softwareklemme 500 weist eine Speichereinheit 501 und eine Anschalteinheit 503 auf, die eine Empfangseinheit Rx und eine Sendeeinheit Tx aufweist.

Der Buskoppler 701 ist an einem vorderen Ende des Klemmensystems 700 ausgebildet und dient dazu, einen Anschluss des Klemmensystems 700 an einen Datenbus 307 eines Automatisierungssystems 300 bereitzustellen.

Die Softwareklemme 500 und die weiteren Teilnehmerklemmen 600 sind mittels der ersten Anschlüsse 505, der zweiten Anschlüsse 507, der dritten Anschlüsse 609 und der vierten Anschlüsse 611, die jeweils in Fig. 7 nicht gezeigt sind, miteinander verbunden. Die Datenübertragung beziehungsweise die Datenkommunikation der einzelnen Klemmen 500 und 600 des Klemmensystems 700 kann über einen internen Datenbus, beispielsweise einen K-Bus (Kommunikationsbus), realisiert werden. Der interne Datenbus (K-Bus) kann sich vom Datenbus 307 des Automatisierungssystems 300, der über ein Feldbussystem realisiert sein kann, in Bezug auf die Signalübertragung und gegebenenfalls die übertragenen Busprotokolle unterscheiden.

Der Buskoppler 701 dient hierbei dazu, die vom Datenbus 307 übertragenen Signale in Signale des internen Datenbusses (K-Bus) umzuwandeln und so eine Datenkommunikation zwischen der Softwareklemme 500 und den weiteren Teilnehmerklemmen 600 innerhalb des Klemmensystems 700 über den internen Datenbus (K-Bus) zu realisieren. Darüber hinaus kann der Buskoppler 701 eine Umwandlung der über den Datenbus 307 übertragenen Busprotokolle, beispielsweise der Telegramme des Felsbusprotokolls EtherCAT, in Busprotokolle umwandeln, die einer Datenübertragung des internen Datenbusses (K-Bus) entsprechen.

Der Buskoppler 701 kann über eine externe Schnittstelle 705 Busprotokolle, beispielsweise Telegramme, empfangen, in entsprechende Busprotokolle, die einer Datenübertragung über den internen Bus (K-Bus) entsprechen, umwandeln und die umgewandelten Busprotokolle an die Softwareklemme 500 weiterleiten.

Die Softwareklemme 500 empfängt mittels der Empfangseinheit Rx die vom Buskoppler 701 weitergeleiteten Busprotokolle, beantwortet die entsprechenden an sie gerichteten Abfragenachrichten und sendet die überarbeiteten Busprotokolle mittels der Sendeeinheit Tx über den internen Datenbus (K-Bus) an die nachfolgenden weiteren Teilnehmerklemmen 600.

Diese wiederum empfangen mittels der jeweiligen Empfangseinheiten Rx die weitergesendeten Busprotokolle, bearbeiten die entsprechenden Abfragenachrichten beziehungsweise Funktionsanweisungen und senden die bearbeiteten Busprotokolle über die entsprechenden Sendeeinheiten Tx an die jeweils nachfolgenden weiteren Teilnehmerklemmen 600.

Die von der Steuerung 301 eines Automatisierungssystems 300 ausgesendeten Abfragenachrichten in Form von Busprotokollen, beispielsweise Telegrammen, können somit von dem Buskoppler 701 des Klemmensystems 700 empfangen, zur Übertragung über den internen Datenbus (K-Bus) des Klemmensystems 700 entsprechend modifiziert und an die Klemmen des Klemmensystems 700 weitergeleitet werden, die die entsprechenden Abfragenachrichten beziehungsweise Funktionsanweisungen beantworten beziehungsweise ausführen und die entsprechenden Antwortnachrichten beziehungsweise Ergebnisse, wie Messdaten, in das jeweilige Busprotokoll einfügen, sodass das Busprotokoll alle Klemmen des Klemmensystems 700 durchläuft, bevor dieses an die Steuerung 301 zurückgesendet wird.

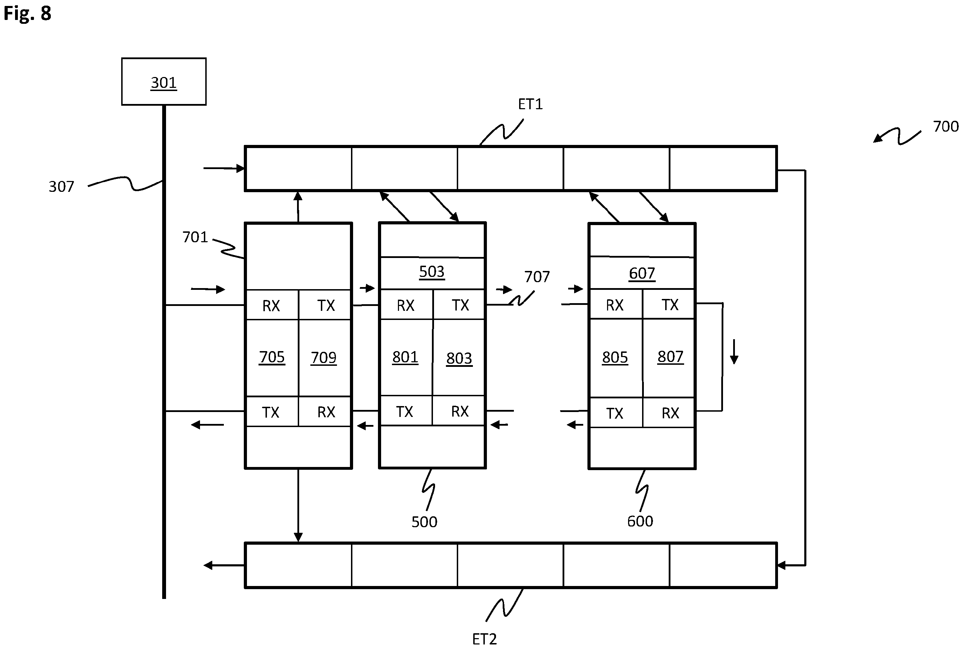

Fig. 8 zeigt eine schematische Darstellung einer Datenkommunikation des Klemmensystems 700 mit einer Steuerung 301 eines Automatisierungssystems 300 über einen Datenbus 307.

In Fig. 8 ist die unter Fig. 7 beschriebene Datenübertragung innerhalb des Klemmensystems 700 schematisch verdeutlicht. Vorliegend umfasst das Klemmensystem 700 einen Buskoppler 701, eine Softwareklemme 500 und eine Teilnehmerklemme 600. Aus darstellerischen Gründen wurde auf die Darstellung weiterer Teilnehmerklemmen verzichtet.

Der Buskoppler 701 umfasst eine externe Schnittstelle 705, mit der der Buskoppler 701 mit dem Datenbus 307 des Automatisierungssystems 300 verbunden ist. Ferner umfasst der Buskoppler 701 eine interne Schnittstelle 709, über die der Buskoppler 701 mit der Softwareklemme 500 und den weiteren Klemmen 600 verbunden ist.

Der Buskoppler 701, die Softwareklemme 500 und die weiteren Teilnehmerklemmen 600 sind über einen internen Datenbus 707 miteinander verbunden.

Die externe Schnittstelle 705 des Buskopplers 701 weist eine Empfangseinheit Rx und eine Sendeeinheit Tx auf. Die interne Schnittstelle 709 des Buskopplers 701 weist ebenfalls eine Empfangseinheit Rx und eine Sendeeinheit Tx auf. Die Softwareklemme 500 weist ebenfalls zwei Empfangseinheiten Rx und zwei Sendeeinheiten Tx auf, die jeweils paarweise zusammen eine erste Übertragungseinrichtung 801 und eine zweite Übertragungseinrichtung 803 bilden. Die Teilnehmerklemme 600 weist wiederum jeweils zwei Empfangseinheiten Rx und zwei Sendeeinheiten Tx auf, die wiederum paarweise zusammen eine dritte Übertragungseinrichtung 805 und eine vierte Übertragungseinrichtung 807 bilden.

Die Empfangseinheit Rx der externen Schnittstelle 705 und die Sendeeinheit Tx der internen Schnittstelle 709 des Buskopplers 701, die Empfangseinheit Rx der ersten Übertragungseinrichtung 801 und die Sendeeinheit Tx der zweiten Übertragungseinrichtung 803 der Softwareklemme 500 und die Empfangseinheit Rx der dritten Übertragungseinrichtung 805 und die Sendeeinheit Tx der vierten Übertragungseinrichtung 807 der weiteren Teilnehmerklemme 600 bilden eine Hinrichtung des internen Datenbusses 707, die durch die von links nach rechts weisenden Pfeile gekennzeichnet ist.

Die Empfangseinheit Rx der vierten Übertragungseinrichtung 807 und die Sendeeinheit Tx der dritten Übertragungseinrichtung 805 der weiteren Teilnehmerklemme 600, die Empfangseinheit Rx der zweiten Übertragungseinrichtung 803 und die Sendeeinheit Tx der ersten Übertragungseinrichtung 801 der Softwareklemme 500 und die Empfangseinheit Rx der internen Schnittstelle 709 und die Sendeeinheit Tx der externen Schnittstelle 705 des Buskopplers 701 bilden eine Rückrichtung des internen Datenbusses 707, die durch die von rechts nach links weisenden Pfeile gekennzeichnet ist.

Der Buskoppler 701 empfängt ein Busprotokoll, beispielsweise ein Telegramm, über den Datenbus 307 mittels der Empfangseinheit Rx der externen Schnittstelle 705. Nach entsprechender Anpassung des empfangenen Busprotokolls und Anpassung an den internen Datenbus 707 sendet der Buskoppler 701 das Busprotokoll als ein Busprotokoll des internen Datenbusses 707, vorliegend als erstes Protokoll ET1 gekennzeichnet, mittels der Sendeeinheit Tx der internen Schnittstelle 709 an die Empfangseinheit Rx der ersten Übertragungseinrichtung 801 der Softwareklemme 500.

Das erste Protkoll ET1 kann beispielsweise ein Telegramm eines Feldbussystems sein.

Die Softwareklemme 500 liest das empfangene erste Protokoll ET1 mittels der Anschalteinheit 503 aus und fügt die Änderungsanweisung an die entsprechende für die Softwareklemme 500 vorgesehene Stelle in das erste Protokoll ET1 ein. Darauffolgend sendet die Softwareklemme 500 über die Sendeeinheit Tx der zweiten Übertragungseinrichtung 803 das bearbeitete erste Protokoll ET1 über den internen Datenbus 707 an die Teilnehmerklemme 600.

Die Teilnehmerklemme 600 empfängt das erste Protokoll ET1 über die Empfangseinheit Rx der dritten Übertragungseinrichtung 805, liest das erste Protokoll ET1 mittels der zweiten Anschalteinheit 607 aus und fügt die angeforderten Daten, beispielsweise Messdaten eines an die Teilnehmerklemme 600 angeschlossenen Geräts des Automatisierungssystems 300, in die entsprechende Stelle in das erste Protokoll ET1 ein und sendet das erste Protokoll ET1 mittels der Sendeeinheit Tx der vierten Übertragungseinrichtung 807 an eine Teilnehmerklemme 600.

Die letzte Teilnehmerklemme 600 des Klemmensystems 700 sendet das erste Protokoll ET1 über die Sendeeinheit Tx der dritten Übertragungseinrichtung 805 auf der Rückrichtung des internen Datenbusses 707 an die vorgeschalteten weiteren Teilnehmerklemmen 600 beziehungsweise an die vorgeschaltete Softwareklemme 500.

Das Auslesen des ersten Protokolls ET1 beziehungsweise das Einfügen der Änderungsanweisung durch die Softwareklemme 500 ist durch die von der Softwareklemme 500 zum ersten Protokoll ET1 weisenden und von dem ersten Protokoll ET1 zur Softwareklemme 500 weisenden Pfeile gekennzeichnet.

Das Auslesen des ersten Protokolls ET1 und das Einfügen von Messdaten durch die Teilnehmerklemme 600 ist durch die von der weiteren Teilnehmerklemme 600 zum ersten Protokoll ET1 weisenden und von dem ersten Protokoll ET1 zur weiteren Teilnehmerklemme 600 weisenden Pfeile gekennzeichnet.

Zur vereinfachten Darstellung ist vorliegend das auf der Rückrichtung des internen Datenbusses 707 von der letzten weiteren Teilnehmerklemme 600 in Richtung des Buskopplers 701 zurückgesendete erste Protokoll ET1 als ein zweites Protokoll ET2 dargestellt.

Das zweite Protokoll ET2 durchläuft wiederum die weiteren Klemmen 600 und die Softwareklemme 500 des Klemmensystems 700. Eine weitere Bearbeitung des zweiten Protokolls ET2 durch die Klemmen des Klemmensystems 700 findet jedoch nicht statt.

Der Buskoppler 701 empfängt das zweite Protokoll ET2 mittels der Empfangseinheit Rx der internen Schnittstelle 709 und wandelt das zweite Protokoll ET2 in ein Busprotokoll des Datenbusses 307 um und sendet das umgewandelte zweite Protokoll ET2 über die Sendeeinheit Tx der externen Schnittstelle 705 über den Datenbus 307 zur Steuerung 301.

Die hier dargestellte Datenübertragung eines Busprotokolls, beispielsweise eines Telegramms, von einem Datenbus 307 eines Automatisierungssystems 300 in einem Klemmensystem 700 mit Buskoppler 701, wenigstens einer Softwareklemme 500 und wenigstens einer weiteren Teilnehmerklemme 600 dient lediglich illustrativen Zwecken.

Eine tatsächliche Datenübertragung über einen Datenbus 307 eines Automatisierungssystems 300 in einem Klemmensystem 700 kann von dem hier gezeigten schematischen Ablauf abweichen und zusätzliche Merkmale aufweisen, beziehungsweise können in Fig. 8 gezeigte Merkmale weggelassen sein.

Beispielsweise kann das erste Protokoll ET1 anstatt zu Buskoppler 701 an ein weiteres in der Fig. 8 nicht gezeigtes Klemmensystem weitergeleitet werden. Erst von diesem weiteren Klemmensystem kann nach vollständiger Bearbeitung des ersten Protokolls ET1 diese wiederum als zweites Protokoll ET2 auf der Rückrichtung und über das Klemmensystem 700 der Fig. 8 an die Steuerung zurückgesendet werden.

Es sind auch weitere Abänderungen der Datenübertragung denkbar.

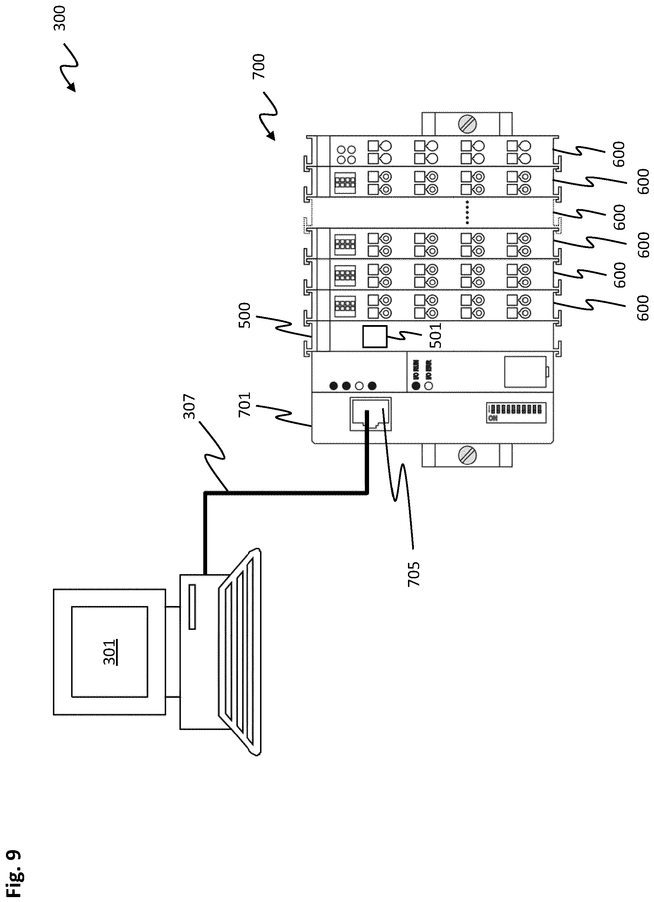

Fig. 9 zeigt eine schematische Darstellung eines Automatisierungssystems 300, bei dem das Klemmensystem 700 in Fig. 7 über einen Datenbus 307 mit einer Steuerung 301 des Automatisierungssystems 300 verbunden ist, gemäß einer Ausführungsform.

Die Steuerung 301 ist in Fig. 9 als ein Steuerungs-PC dargestellt. Abweichend kann die Steuerung 301 auch als eine integrierte Steuerung, eine serverbasierte oder als eine netzwerkbasierte Steuerung ausgebildet sein.

Darüber hinaus kann das Klemmensystem 700 zusätzliche Teilnehmerklemmen 600 beziehungsweise zusätzliche Softwareklemmen 500 umfassen. Ferner kann das Automatisierungssystem 300 mehrere Klemmensysteme 700 umfassen.

Die Softwareklemme 500 kann die folgenden Funktionen aufweisen:
1. Identifizierung einer weiteren Teilnehmerklemme 600 und eines an der weiteren Teilnehmerklemme 600 angeschlossenen Geräts. Über die Speicherung auf der Softwareklemme 500 einer Steuerungssoftware, spezifischen Betriebsparametern, individuellen Identifizierungskennungen und weiteren Informationen bezüglich des an die Teilnehmerklemme 600 angeschlossenen Geräts innerhalb der Änderungsanweisung der Softwareklemme 500 kann die Softwareklemme 500 bei der Durchführung des oben beschriebenen Verfahrens 100 zur Änderung einer Steuerungssoftware eines Automatisierungssystems 300 ein neu in das Automatisierungssystem 300 eingefügtes, an die Teilnehmerklemme 600 angeschlossenes, Gerät identifizieren, sodass die Steuerung 301 des Automatisierungssystems nach entsprechender Änderung der Steuerungssoftware das neu in das Automatisierungssystem 300 eingefügte Gerät individuell ansprechen und steuern kann.
2. Darüber hinaus kann die Änderungsanweisung auf der Speichereinheit 501 der Softwareklemme 500 gespeichert werden. Für den eigentlichen Betrieb beziehungsweise die Ausführung der Änderungsanweisung wird die Änderungsanweisung in der Steuerung 301 des Automatisierungssystems 300 installiert und durch die Steuerung 301 ausgeführt. Einen eigenständigen Controller zur Ausführung der Änderungsanweisung, beziehungsweise zur Ausführung der in der Änderungsanweisung gespeicherten Steuerungssoftware eines neu in das Automatisierungssystem 300 eingefügten Geräts ist nicht notwendig. Applikationen, die eine hohe Rechenleistung benötigen, können somit auf den Hauptrechner der Steuerung 301 des Automatisierungssystems 300 übertragen werden.
3. Darüber hinaus kann eine Steuerungssoftware des neu in das Automatisierungssystem 300 eingefügten Geräts mittels einer entsprechenden Lizensierung, die im Zuge der Änderungsanweisung auf der Speichereinheit 501 der Softwareklemme 500 gespeichert ist, bereitgestellt werden. So kann versichert werden, dass ausschließlich lizensierte Software zur Steuerung 301 des zusätzlichen Geräts verwendet werden kann. Hierdurch können Qualitäts- und Sicherheitsstandards des Automatisierungssystems 300 gewahrt werden.
4. Die Softwareklemme 500 kann in einem wie oben beschriebenen Klemmensystem 700 zur Adressierung durch die Steuerung 301 der in dem Klemmensystem 700 hinter der Softwareklemme 500 angeordneten weiteren Teilnehmerklemmen 600, die jeweils neu in das Automatisierungssystem 300 eingefügte Geräte umfassen, dienen. Bei Identifizierung der Softwareklemme 500 und der über die weiteren Teilnehmerklemmen 600 neu in das Automatisierungssystem 300 eingefügten zusätzlichen Geräte durch die Steuerung 301 kann die Steuerung die Adressierung der zusätzlichen Geräte über die Anordnung der jeweiligen weiteren Teilnehmerklemmen 600 relativ zu der Softwareklemme 500 adressieren, indem die Softwareklemme 500 als ein Adressierungsnullpunkt bezüglich der mittels den weiteren Teilnehmerklemmen 600 hinter der Softwareklemme 500 angeordneten zusätzlichen Geräte dient. Eine Adressierung der zusätzlichen Geräte kann dann beispielsweise mittels einer Abzählung der Stellen innerhalb des Klemmensystems 700 relativ zur Softwareklemme 500, an denen die zu den zusätzlichen Geräten gehörigen weiteren Teilnehmerklemmen 600 im Klemmensystem 700 angeordnet sind, erfolgen. Eine zusätzliche Adressierung ist somit nicht notwendig.

### Bezugszeichenliste

- 100: Verfahren zur Änderung einer Steuerungssoftware eines Automatisierungssystems
- 101: Abfrageschritt
- 103: erster Antwortschritt
- 105: Überprüfungsschritt
- 107: Änderungsschritt
- 109: Verwerfungsschritt
- 111: Fehlermeldungsschritt
- 201: Installationsschritt
- 203: weiterer Abfrageschritt
- 205: zweiter Antwortschritt
- 207: Identifizierungsschritt
- 300: Automatisierungssystem
- 301: Steuerung
- 303: Software-Teilnehmer
- 305: Teilnehmer
- 307: Datenbus
- 401: zusätzlicher Teilnehmer
- 500: Softwareklemme
- 501: Speichereinheit
- 503: Anschalteinheit
- 505: erster Anschluss
- 507: zweiter Anschluss
- 600: Teilnehmerklemme
- 601: Anschlusseinrichtung
- 603: Anschlussöffnung
- 605: Anzeigeeinrichtung
- 607: zweite Anschalteinheit
- 609: dritter Anschluss
- 611: vierter Anschluss
- 700: Klemmensystem
- 701: Buskoppler
- 703: Tragschiene
- 705: externe Schnittstelle
- 707: interner Datenbus
- 709: interne Schnittstelle
- 801: erste Übertragungseinrichtung
- 803: zweite Übertragungseinrichtung
- 805: dritte Übertragungseinrichtung
- 807: vierte Übertragungseinrichtung
- ET1: erstes Protokoll
- ET2: zweites Protokoll
- Rx: Empfangseinheit
- Tx: Sendeeinheit

## Patentansprüche

1. Verfahren (100) zum Ändern einer Steuerungssoftware eines Automatisierungssystems (300) mit einer Steuerung (301) und einer Mehrzahl von Teilnehmern (303, 305, 401), wobei die Teilnehmer (303, 305, 401) über einen Datenbus (307) mit der Steuerung (301) verbunden sind und über einen Datenaustausch kommunizieren, wobei der Datenbus (307) als ein Feldbus ausgebildet ist, wobei zumindest ein Teilnehmer der Mehrzahl von Teilnehmern (303, 305, 401) ein Software-Teilnehmer (303) zum Ändern einer Steuerungssoftware der Steuerung (301) ist, wobei der Software-Teilnehmer (303) als eine Software-Klemme (500) ausgebildet ist, wobei die Software-Klemme (500) als eine Busklemme ausgebildet ist, und wobei der Software-Teilnehmer (303) eine Speichereinheit (501) umfasst, auf der wenigstens eine Änderungsanweisung zur Änderung der Steuerungssoftware abgespeichert ist, wobei die wenigstens eine Änderungsanweisung einen zu ändernden Teil der Steuerungssoftware und/oder einen zusätzlichen Teil der Steuerungssoftware umfasst, **gekennzeichnet durch**:
- Senden einer individuellen Abfragenachricht **durch** die Steuerung (301) an den Software-Teilnehmer (303) zur Abfrage der wenigstens einen Änderungsanweisung zur Änderung der Steuerungssoftware in einem Abfrageschritt (101);
- Senden einer Antwortnachricht **durch** den Software-Teilnehmer (303) an die Steuerung (301) zum Bereitstellen der wenigstens einen Änderungsanweisung zur Änderung der Steuerungssoftware in einem ersten Antwortschritt (103);
- Überprüfen der wenigstens einen Änderungsanweisung zur Änderung der Steuerungssoftware **durch** die Steuerung (301), ob die Änderungsanweisung mit der Steuerungssoftware kompatibel ist, in einem Überprüfungsschritt (105);
- Ändern der Steuerungssoftware gemäß der Änderungsanweisung und Implementieren der Änderung der Änderungsanweisung in die bestehende Steuerungssoftware **durch** die Steuerung (301) in einem Änderungsschritt (107), wenn die Änderungsanweisung mit der Steuerungssoftware kompatibel ist; und
- Verwerfen der Änderungsanweisung **durch** die Steuerung (301) in einem Verwerfungsschritt (109), wenn die Änderungsanweisung mit der Steuerungssoftware nicht kompatibel ist.

2. Verfahren (100) nach Anspruch 1, ferner umfassend:
- Installieren des Software-Teilnehmers (303) in den Datenbus (307) und Verbinden des Software-Teilnehmers (303) mit der Steuerung (301) in einem Installationsschritt (201);
- Senden einer Identifizierungsabfrage durch die Steuerung (301) an die Teilnehmer (303, 305, 401) zur Identifizierung der im Datenbus (307) befindlichen Teilnehmer (303, 305, 401) in einem weiteren Abfrageschritt (203);
- Senden einer Identifizierungsantwort durch den Software-Teilnehmer (303) an die Steuerung (301) in einem zweiten Antwortschritt (205);
- Identifizieren des Software-Teilnehmers (303) als einen Teilnehmer der Mehrzahl von Teilnehmern (303, 305, 401), der zur Änderung der Steuerungssoftware dient, durch die Steuerung (301) auf Basis der Identifizierungsantwort in einem Identifizierungsschritt (207).

3. Verfahren (100) nach einem der vorangehenden Ansprüche, wobei der Verwerfungsschritt (109) umfasst:
- Ausgeben einer Fehlermeldung durch die Steuerung (301) in einem Fehlermeldungsschritt (111).

4. Verfahren (100) nach einem der vorangehenden Ansprüche, wobei das Verfahren (100) in einer Startphase des Automatisierungssystems, in der das Automatisierungssystem nicht in Betrieb ist, oder in einem laufenden Betrieb des Automatisierungssystems (300) durchführbar ist, indem in der Startphase ein Auffahren der Steuerungssoftware durchgeführt wird und durch die Steuerung (301) der Software-Teilnehmer (303) als zusätzlicher Teilnehmer erkannt wird, oder indem in dem laufenden Betrieb des Automatisierungssystems (300) der Software-Teilnehmer (303) in einen Bereich des Automatisierungssystems (300) eingefügt ist, der sich in einem Konfigurationszustand befindet, und durch die Steuerung (301) der Software-Teilnehmer (303) als zusätzlicher Teilnehmer erkannt wird.

5. Verfahren (100) nach einem der vorangehenden Ansprüche, wobei die Änderungsanweisung ein Update oder eine Modifikation der Steuerungssoftware umfasst.

6. Verfahren (100) nach einem der vorangehenden Ansprüche, wobei die Änderung der Steuerungssoftware gemäß dem Änderungsschritt das Einbinden wenigstens eines zusätzlichen Teilnehmers (401) zu der Mehrzahl von Teilnehmern (303, 305, 401), der nicht der Software-Teilnehmer (303) ist, in den Datenbus (307) des Automatisierungssystems (300) umfasst.

7. Verfahren (100) nach einem der vorangehenden Ansprüche, wobei die Änderungsanweisung eine Identifizierung, eine Steuerungssoftware, spezifische Betriebsparameter oder eine Lizensierung der Steuerungssoftware wenigstes eines Teilnehmers (305, 401) der Mehrzahl von Teilnehmern (303, 305, 401) umfasst.

8. Verfahren (100) nach Anspruch 6 oder 7, wobei der wenigstens eine zusätzliche Teilnehmer (401) über eine Datenbusleitung mit dem Software-Teilnehmer (303) verbunden ist, wobei über die Datenbusleitung ein Kommunikationsbus eines Klemmensystems definiert ist.

9. Softwareklemme (500) zur Änderung nach einem Verfahren gemäß einem der Ansprüche 1 bis 8 einer Steuerungssoftware eines Automatisierungssystems (300) mit einer Steuerung (301) und einer Mehrzahl von Teilnehmern (303, 305, 401), die über einen Datenbus (307) mit der Steuerung (301) verbunden sind,
wobei die Softwareklemme (500) als ein Teilnehmer der Mehrzahl von Teilnehmern (303, 305, 401) in das Automatisierungssystem (300) integrierbar ist und als eine Bus-Klemme zur Verwendung in dem Datenbus (307) ausgebildet ist, **dadurch gekennzeichnet,**
**dass** die Softwareklemme (500) wenigstens eine Speichereinheit (501) aufweist, auf der wenigstens eine Änderungsanweisung zur Änderung der Steuerungssoftware der Steuerung (301) des Automatisierungssystems (300) speicherbar ist, und dass die Softwareklemme (500) eine Anschalteinheit (503) aufweist, die ausgebildet ist, mit der Steuerung (301) und/oder anderen Teilnehmern des Automatisierungssystems (300) über den Austausch von Daten über den Datenbus (307) zu kommunizieren und der Steuerung (301) des Automatisierungssystems (300) wenigstens eine auf der Speichereinheit (501) gespeicherte Änderungsanweisung zur Änderung der Steuerungssoftware der Steuerung (300) bereitzustellen, wobei die wenigstens eine Änderungsanweisung einen zu ändernden Teil der Steuerungssoftware und/oder einen zusätzlichen Teil der Steuerungssoftware umfasst.

10. Klemmensystem (700) zur Verwendung in einem Automatisierungssystem (300), umfassend:
eine Mehrzahl von Teilnehmerklemmen (600) und wenigstens eine Softwareklemme (500) nach Anspruch 9, **dadurch gekennzeichnet, dass** die Mehrzahl von Teilnehmerklemmen (600) und die wenigstens eine Softwareklemme (500) als Bus-Klemmen ausgebildet sind und über eine interne Busleitung miteinander verbunden sind; und
einen Buskoppler (701), wobei der Buskoppler (701) ausgebildet ist, das Klemmensystem (700) an einen Datenbus (307) des Automatisierungssystems (300) anzubinden.

11. Automatisierungssystem (300), umfassend eine Steuerung (301), eine Mehrzahl von Teilnehmern (303, 305, 401) , die mit der Steuerung (301) über einen Datenbus (307) verbunden und eingerichtet sind, über den Austausch von Daten mit der Steuerung (301) zu kommunizieren, wobei der Datenbus (307) als ein Feldbus ausgebildet ist, wobei die Steuerung (301) mit einer Steuerungssoftware die Mehrzahl von Teilnehmern (303, 305, 401) ansteuert, wobei wenigstens ein Teilnehmer der Mehrzahl von Teilnehmern (303, 305, 401) ein Software-Teilnehmer (303) ist, und wobei der Software-Teilnehmer (303) als eine Software-Klemme (500) gemäß Anspruch 9 ausgebildet ist, **dadurch gekennzeichnet,**
- **dass** die Steuerung (301) ausgebildet ist, eine individuelle Abfragenachricht an den Software-Teilnehmer zur Abfrage der wenigstens einen Änderungsanweisung zur Änderung der Steuerungssoftware zu senden;
- **dass** der Software-Teilnehmer (303) ausgebildet ist, die wenigstens eine Änderungsanweisung zur Änderung der Steuerungssoftware an die Steuerung (301) zu senden;
- **dass** die Steuerung (301) ausgebildet ist, die wenigstens eine Änderungsanweisung zur Änderung der Steuerungssoftware zu überprüfen, ob die Änderungsanweisung mit der Steuerungssoftware kompatibel ist;
- **dass** die Steuerung (301) ausgebildet ist, die Steuerungssoftware gemäß der Änderungsanweisung zu ändern und die Änderung der Änderungsanweisung in die bestehende Steuerungssoftware zu implementieren, wenn die Änderungsanweisung mit der Steuerungssoftware kompatibel ist; und
- **dass** die Steuerung (301) ausgebildet ist, die Änderungsanweisung zu verwerfen, wenn die Änderungsanweisung mit der Steuerungssoftware nicht kompatibel ist.

12. Automatisierungssystem (300) nach Anspruch 11, wobei die Steuerung (301) und der Software-Teilnehmer (303) ausgebildet sind, eine Änderung der Steuerungssoftware gemäß der wenigstens einen Änderungsanweisung während einer Startphase des Automatisierungssystems (300), in der das Automatisierungssystem (300) nicht in Betrieb ist, oder in einem laufenden Betrieb des Automatisierungssystems (300) durchzuführen, indem in der Startphase ein Auffahren der Steuerungssoftware durchgeführt wird und durch die Steuerung (301) der Software-Teilnehmer (303) als zusätzlicher Teilnehmer zu der Mehrzahl von Teilnehmern (303, 305, 401) erkannt wird, oder indem in dem laufenden Betrieb des Automatisierungssystems (300) der Software-Teilnehmer (303) in einen Bereich des Automatisierungssystems (300) eingefügt ist, der sich in einem Konfigurationszustand befindet, und durch die Steuerung (301) der Software-Teilnehmer (303) als zusätzlicher Teilnehmer in der Mehrzahl von Teilnehmern (303, 305, 401) erkannt wird.

13. Automatisierungssystem (300) nach Anspruch 11 oder 12, wobei die Steuerung (301) ausgebildet ist, durch die Änderung der Steuerungssoftware auf Basis der wenigstens einen Änderungsanweisung wenigstens einen zusätzlichen Teilnehmer (401) zu der Mehrzahl von Teilnehmern (303, 305, 401) in das Automatisierungssystem (300) einzupflegen.

14. Automatisierungssystem (300) nach Anspruch 11, 12 oder 13, wobei die Änderungsanweisung ein Update oder eine Modifikation der Steuerungssoftware umfasst.

15. Automatisierungssystem (300) nach einem der vorangehenden Ansprüche 11 bis 14, wobei die Änderungsanweisung eine Identifizierung, eine Steuerungssoftware, spezifische Betriebsparameter oder eine Lizensierung der Steuerungssoftware zumindest eines Teilnehmers (305, 401) der Mehrzahl von Teilnehmern (303, 305, 401) umfasst.

## Claims

1. Method (100) for changing control software of an automation system (300) comprising a controller (301) and a plurality of subscribers (303, 305, 401), wherein the subscribers (303, 305, 401) are connected to the controller (301) via a data bus (307) and communicate via a data exchange, wherein the data bus (307) is configured as a field bus, wherein at least one subscriber of the plurality of subscribers (303, 305, 401) is a software subscriber (303) for changing control software of the controller (301), wherein the software subscriber (303) is configured as a software terminal (500), wherein the software terminal (500) is configured as a bus terminal, and wherein the software subscriber (303) comprises a storage unit (501) on which at least one change instruction for changing the control software is stored, wherein the at least one change instruction comprises a part to be changed of the control software and/or an additional part of the control software, **characterized by**:
- sending an individual query message by means of the controller (301) to the software subscriber (303) in order to query the at least one change instruction for changing the control software in a query step (101);
- sending a response message by means of the software subscriber (303) to the controller (301) in order to provide the at least one change instruction for changing the control software in a first response step (103);
- checking the at least one change instruction for changing the control software by means of the controller (301) as to whether the change instruction is compatible with the control software, in a checking step (105);
- changing the control software in accordance with the change instruction and implementing the change of the change instruction in the existing control software by means of the controller (301) in a change step (107) if the change instruction is compatible with the control software; and
- discarding the change instruction by means of the controller (301) in a discarding step (109) if the change instruction is incompatible with the control software.

2. Method (100) according to Claim 1, furthermore comprising:
- installing the software subscriber (303) in the data bus (307) and connecting the software subscriber (303) to the controller (301) in an installation step (201);
- sending an identification query by means of the controller (301) to the subscribers (303, 305, 401) in order to identify the subscribers (303, 305, 401) located on the data bus (307) in a further query step (203);
- sending an identification response by means of the software subscriber (303) to the controller (301) in a second response step (205);
- identifying the software subscriber (303) as a subscriber of the plurality of subscribers (303, 305, 401) which serves for changing the control software by means of the controller (301) on the basis of the identification response in an identification step (207).

3. Method (100) according to any one of the preceding claims, wherein the discarding step (109) comprises:
- outputting an error message by means of the controller (301) in an error message step (111).

4. Method (100) according to any one of the preceding claims, wherein the method (100) is able to be carried out in a start phase of the automation system, in which the automation system is not in operation, or in ongoing operation of the automation system (300) by virtue of the fact that, in the start phase, a start-up of the control software is carried out and the controller (301) recognizes the software subscriber (303) as an additional subscriber, or by virtue of the fact that, in ongoing operation of the automation system (300), the software subscriber (303) is inserted in an area of the automation system (300) which is in a configuration state, and the controller (301) recognizes the software subscriber (303) as an additional subscriber.

5. Method (100) according to any one of the preceding claims, wherein the change instruction comprises an update or a modification of the control software.

6. Method (100) according to any one of the preceding claims, wherein the change of the control software in accordance with the change step comprises including at least one additional subscriber (401) with respect to the plurality of subscribers (303, 305, 401), said at least one additional subscriber not being the software subscriber (303), in the data bus (307) of the automation system (300).

7. Method (100) according to any one of the preceding claims, wherein the change instruction comprises an identification, control software, specific operating parameters or a licensing of the control software of at least one subscriber (305, 401) of the plurality of subscribers (303, 305, 401).

8. Method (100) according to Claim 6 or 7, wherein the at least one additional subscriber (401) is connected to the software subscriber (303) via a data bus line, wherein a communication bus of a terminal system is defined via the data bus line.

9. Software terminal (500) for changing, according to a method according to any one of Claims 1 to 8, control software of an automation system (300) comprising a controller (301) and a plurality of subscribers (303, 305, 401) connected to the controller (301) via a data bus (307),
wherein the software terminal (500) is able to be integrated into the automation system (300) as a subscriber of the plurality of subscribers (303, 305, 401) and is configured as a bus terminal for use in the data bus (307), **characterized**
**in that** the software terminal (500) comprises at least one storage unit (501) on which at least one change instruction for changing the control software of the controller (301) of the automation system (300) is able to be stored, and
**in that** the software terminal (500) comprises an interface unit (503) configured to communicate with the controller (301) and/or other subscribers of the automation system (300) via the exchange of data via the data bus (307) and to provide for the controller (301) of the automation system (300) at least one change instruction for changing the control software of the controller (301), said at least one change instruction being stored on the storage unit (501), wherein the at least one change instruction comprises a part to be changed of the control software and/or an additional part of the control software.

10. Terminal system (700) for use in an automation system (300), comprising:
a plurality of subscriber terminals (600) and at least one software terminal (500) according to Claim 9, **characterized in that** the plurality of subscriber terminals (600) and the at least one software terminal (500) are configured as bus terminals and are connected to one another via an internal bus line; and a bus coupler (701), wherein the bus coupler (701) is configured to link the terminal system (700) to a data bus (307) of the automation system (300).

11. Automation system (300), comprising a controller (301), a plurality of subscribers (303, 305, 401) which are connected to the controller (301) via a data bus (307) and are set up to communicate with the controller (301) via the exchange of data, wherein the data bus (307) is configured as a field bus, wherein the controller (301) controls the plurality of subscribers (303, 305, 401) by way of control software, wherein at least one subscriber of the plurality of subscribers (303, 305, 401) is a software subscriber (303), and wherein the software subscriber (303) is configured as a software terminal (500) according to Claim 9, **characterized**
- **in that** the controller (301) is configured to send an individual query message to the software subscriber in order to query the at least one change instruction for changing the control software;
- **in that** the software subscriber (303) is configured to send the at least one change instruction for changing the control software to the controller (301);
- **in that** the controller (301) is configured to check the at least one change instruction for changing the control software as to whether the change instruction is compatible with the control software;
- **in that** the controller (301) is configured to change the control software in accordance with the change instruction and to implement the change of the change instruction in the existing control software if the change instruction is compatible with the control software; and
- **in that** the controller (301) is configured to discard the change instruction if the change instruction is incompatible with the control software.

12. Automation system (300) according to Claim 11, wherein the controller (301) and the software subscriber (303) are configured to carry out a change of the control software in accordance with the at least one change instruction during a start phase of the automation system (300), in which the automation system (300) is not in operation, or in ongoing operation of the automation system (300) by virtue of the fact that, in the start phase, a start-up of the control software is carried out and the controller (301) recognizes the software subscriber (303) as an additional subscriber with respect to the plurality of subscribers (303, 305, 401), or by virtue of the fact that, in ongoing operation of the automation system (300), the software subscriber (303) is inserted in an area of the automation system (300) which is in a configuration state, and the controller (301) recognizes the software subscriber (303) as an additional subscriber in the plurality of subscribers (303, 305, 401).

13. Automation system (300) according to Claim 11 or 12, wherein the controller (301) is configured, by way of the change of the control software on the basis of the at least one change instruction, to incorporate at least one additional subscriber (401) with respect to the plurality of subscribers (303, 305, 401) in the automation system (300) .

14. Automation system (300) according to Claim 11, 12 or 13, wherein the change instruction comprises an update or a modification of the control software.

15. Automation system (300) according to any one of the preceding Claims 11 to 14, wherein the change instruction comprises an identification, control software, specific operating parameters or a licensing of the control software of at least one subscriber (305, 401) of the plurality of subscribers (303, 305, 401).

## Revendications

1. Procédé (100) pour modifier un logiciel de commande d'un système d'automatisation (300) comprenant une commande (301) et une pluralité de périphériques (303, 305, 401), les périphériques (303, 305, 401) étant reliés à la commande (301) par le biais d'un bus de données (307) et communiquant par le biais d'un échange de données, le bus de données (307) étant réalisé sous la forme d'un bus de terrain, au moins un périphérique de la pluralité de périphériques (303, 305, 401) étant un périphérique logiciel (303) destiné à modifier un logiciel de commande de la commande (301), le périphérique logiciel (303) étant réalisé sous la forme d'une borne logicielle (500), la borne logicielle (500) étant réalisée sous la forme d'une borne de bus et le périphérique logiciel (303) comportant une unité de mémoire (501) sur laquelle est enregistrée au moins une instruction de modification destinée à modifier le logiciel de commande, l'au moins une instruction de modification comprenant une partie à modifier du logiciel de commande et/ou une partie supplémentaire du logiciel de commande, **caractérisé par** :
- envoi d'un message d'interrogation individuel par la commande (301) au périphérique logiciel (303) pour interroger l'au moins une instruction de modification destinée à modifier le logiciel de commande dans une étape d'interrogation (101) ;
- envoi d'un message de réponse par le périphérique logiciel (303) à la commande (301) pour fournir l'au moins une instruction de modification destinée à modifier le logiciel de commande dans une étape de réponse (103) ;
- contrôle de l'au moins une instruction de modification destinée à modifier le logiciel de commande par la commande (301), afin de vérifier si l'instruction de modification est compatible avec le logiciel de commande, dans une étape de contrôle (105) ;
- modification du logiciel de commande selon l'instruction de modification et mise en œuvre de la modification de l'instruction de modification dans le logiciel de commande existant par la commande (301) dans une étape de modification (107) lorsque l'instruction de modification est compatible avec le logiciel de commande ; et
- rejet de l'instruction de modification par la commande (301) dans une étape de rejet (109) lorsque l'instruction de modification n'est pas compatible avec le logiciel de commande.

2. Procédé (100) selon la revendication 1, comprenant en outre :
- installation du périphérique logiciel (303) dans le bus de données (307) et connexion du périphérique logiciel (303) à la commande (301) dans une étape d'installation (201) ;
- envoi d'une interrogation d'identification par la commande (301) aux périphériques (303, 305, 401) en vue d'identifier le périphérique (303, 305, 401) qui se trouve dans le bus de données (307) dans une étape d'interrogation supplémentaire (203) ;
- envoi d'une réponse d'identification par le périphérique logiciel (303) à la commande (301) dans une deuxième étape de réponse (205) ;
- identification du périphérique logiciel (303) en tant que périphérique de la pluralité de périphériques (303, 305, 401), qui sert à la modification du logiciel de commande, par la commande (301) sur la base de la réponse d'identification dans une étape d'identification (207) .

3. Procédé (100) selon l'une des revendications précédentes, l'étape de rejet (109) comprenant :
- délivrance d'une notification d'erreur par la commande (301) dans une étape de notification d'erreur (111) .

4. Procédé (100) selon l'une des revendications précédentes, le procédé (100) pouvant être mis en œuvre dans une phase de démarrage du système d'automatisation, dans laquelle le système d'automatisation n'est pas en service, ou dans un fonctionnement en cours du système d'automatisation (300), en ce qu'un lancement du logiciel de commande est effectué dans la phase de démarrage et le périphérique logiciel (303) est reconnu par la commande (301) en tant que périphérique supplémentaire, ou en ce que dans le fonctionnement en cours du système d'automatisation (300), le périphérique logiciel (303) est inséré dans une zone du système d'automatisation (300) qui se trouve dans un état de configuration et le périphérique logiciel (303) est reconnu par la commande (301) en tant que périphérique supplémentaire.

5. Procédé (100) selon l'une des revendications précédentes, l'instruction de modification comprenant une mise à jour ou un changement du logiciel de commande.

6. Procédé (100) selon l'une des revendications précédentes, la modification du logiciel de commande selon l'étape de modification comprenant l'intégration d'au moins un périphérique supplémentaire (401) à la pluralité de périphériques (303, 305, 401), lequel n'est pas le périphérique logiciel (303), dans le bus de données (307) du système d'automatisation (300).

7. Procédé (100) selon l'une des revendications précédentes, l'instruction de modification comprenant une identification, un logiciel de commande, des paramètres de fonctionnement spécifiques ou une attribution de licence au logiciel de commande d'au moins un périphérique (305, 401) de la pluralité de périphériques (303, 305, 401).

8. Procédé (100) selon la revendication 6 ou 7, l'au moins un périphérique supplémentaire (401) étant relié au périphérique logiciel (303) par le biais d'une ligne de bus de données, un bus de communication d'un système de bornes étant défini par la ligne de bus de données.

9. Borne logicielle (500) destinée à modifier, conformément à un procédé selon l'une des revendications 1 à 8, un logiciel de commande d'un système d'automatisation (300) comprenant une commande (301) et une pluralité de périphériques (303, 305, 401), qui sont reliés à la commande (301) par le biais d'un bus de données (307),
la borne logicielle (500) pouvant être intégrée dans le système d'automatisation (300) en tant que périphérique de la pluralité de périphériques (303, 305, 401) et étant réalisée sous la forme d'une borne de bus à utiliser dans le bus de données (307), **caractérisée en ce que** la borne logicielle (500) possède au moins une unité de mémoire (501) sur laquelle peut être enregistrée au moins une instruction de modification destinée à modifier le logiciel de commande de la commande (301) du système d'automatisation (300), et
que la borne logicielle (500) possède une unité de connexion (503) qui est configurée pour communiquer avec la commande (301) et/ou d'autres périphériques du système d'automatisation (300) par l'échange de données par le biais du bus de données (307) et fournir à la commande (301) du système d'automatisation (300) au moins une instruction de modification enregistrée sur l'unité de mémoire (501) en vue de modifier le logiciel de commande de la commande (300), l'au moins une instruction de modification comprenant une partie à modifier du logiciel de commande et/ou une partie supplémentaire du logiciel de commande.

10. Système de bornes (700) destiné à être utilisé dans un système d'automatisation (300), comprenant :
une pluralité de bornes périphériques (600) et au moins une borne logicielle (500) selon la revendication 9, **caractérisé en ce que** la pluralité de bornes périphériques (600) et l'au moins une borne logicielle (500) sont réalisées sous la forme de bornes de bus et sont reliées entre elles par le biais d'une ligne de bus interne ; et
un coupleur de bus (701), le coupleur de bus (701) étant configuré pour raccorder le système de bornes (700) à un bus de données (307) du système d'automatisation (300).

11. Système d'automatisation (300), comprenant une commande (301), une pluralité de périphériques (303, 305, 401) qui sont reliés à la commande (301) par le biais d'un bus de données (307) et sont conçus pour communiquer avec la commande (301) par le biais de l'échange de données, le bus de données (307) étant réalisé sous la forme d'un bus de terrain, la commande (301) commandant la pluralité de périphériques (303, 305, 401) avec un logiciel de commande, au moins un périphérique de la pluralité de périphériques (303, 305, 401) étant un périphérique logiciel (303), et le périphérique logiciel (303) étant réalisé sous la forme d'une borne logicielle (500) selon la revendication 9, **caractérisé en ce**
- **que** la commande (301) est configurée pour envoyer un message d'interrogation individuel au périphérique logiciel pour interroger l'au moins une instruction de modification destinée à modifier le logiciel de commande ;
- **que** le périphérique logiciel (303) est configuré pour envoyer l'au moins une instruction de modification destinée à modifier le logiciel de commande à la commande (301) ;
- **que** la commande (301) est configurée pour contrôler l'au moins une instruction de modification destinée à modifier le logiciel de commande, afin de vérifier si l'instruction de modification est compatible avec le logiciel de commande ;
- **que** la commande (301) est configurée pour modifier le logiciel de commande selon l'instruction de modification et mettre en œuvre la modification de l'instruction de modification dans le logiciel de commande existant lorsque l'instruction de modification est compatible avec le logiciel de commande ; et
- **que** la commande (301) est configurée pour rejeter l'instruction de modification lorsque l'instruction de modification n'est pas compatible avec le logiciel de commande.

12. Système d'automatisation (300) selon la revendication 11, la commande (301) et le périphérique logiciel (303) étant configurés pour effectuer une modification du logiciel de commande conformément à l'au moins une instruction de modification pendant une phase de démarrage du système d'automatisation (300), dans laquelle le système d'automatisation (300) n'est pas en service, ou dans un fonctionnement en cours du système d'automatisation (300), en ce qu'un lancement du logiciel de commande est effectué dans la phase de démarrage et le périphérique logiciel (303) est reconnu par la commande (301) en tant que périphérique supplémentaire de la pluralité de périphériques (303, 305, 401), ou en ce que dans le fonctionnement en cours du système d'automatisation (300), le périphérique logiciel (303) est inséré dans une zone du système d'automatisation (300) qui se trouve dans un état de configuration et le périphérique logiciel (303) est reconnu par la commande (301) en tant que périphérique supplémentaire à la pluralité de périphériques (303, 305, 401).

13. Système d'automatisation (300) selon la revendication 11 ou 12, la commande (301) étant configurée pour, par la modification du logiciel de commande sur la base de l'au moins une instruction de modification, incorporer au moins un périphérique supplémentaire (401) à la pluralité de périphériques (303, 305, 401) dans le système d'automatisation (300).

14. Système d'automatisation (300) selon la revendication 11, 12 ou 13, l'instruction de modification comprenant une mise à jour ou un changement du logiciel de commande.

15. Système d'automatisation (300) selon l'une des revendications 11 à 14, l'instruction de modification comprenant une identification, un logiciel de commande, des paramètres de fonctionnement spécifiques ou une attribution de licence au logiciel de commande d'au moins un périphérique (305, 401) de la pluralité de périphériques (303, 305, 401).
